(19) **Europäisches Patentamt European Patent Office Office européen des brevets**

(11) **EP 4 692 007 A1**

(12) **EUROPEAN PATENT APPLICATION**
published in accordance with Art. 153(4) EPC

(43) Date of publication:
**11.02.2026 Bulletin 2026/07**

(21) Application number: **24780076.6**

(22) Date of filing: **22.03.2024**

(51) International Patent Classification (IPC):
*C03C 3/095* (2006.01)     *C03C 4/08* (2006.01)
*C03C 21/00* (2006.01)     *H01L 31/048* (2014.01)

(52) Cooperative Patent Classification (CPC):
**C03C 3/095; C03C 4/08; C03C 21/00; H10F 19/80**

(86) International application number:
**PCT/JP2024/011493**

(87) International publication number:
**WO 2024/203958 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.03.2023  JP 2023054194
06.09.2023  JP 2023144621**

(71) Applicant: **AGC INC.
Chiyoda-ku,
Tokyo 1008405 (JP)**

(72) Inventors:
• **AKIBA, Shusaku
  Tokyo 100-8405 (JP)**
• **KATO, Takeyuki
  Tokyo 100-8405 (JP)**
• **WADA, Naoya
  Tokyo 100-8405 (JP)**

(74) Representative: **Müller-Boré & Partner
Patentanwälte PartG mbB
Friedenheimer Brücke 21
80639 München (DE)**

(54) **GLASS**

(57)    The purpose of the present invention is to provide glass which is superior in electron beam resistance and ultraviolet-shielding effect to conventional ones and has excellent strength. The present invention relates to glass comprising, in terms of oxide amount in percent by mass, 0.4-10% $CeO_2$, 45-85% $SiO_2$, and 0-25% $Al_2O_3$, and more specifically relates to cover glass for solar cells, ultraviolet cut glass, electron-beam cut glass, an optical lens for cosmic space or other optical members for cosmic space, and so on.

**EP 4 692 007 A1**

**Description**

TECHNICAL FIELD

The present invention relates to a glass, and more particularly to a glass suitable as a cover glass for a solar cell, a glass for cutting an ultraviolet ray, a glass for cutting an electron beam, an optical lens for space, an optical member for space, and the like.

BACKGROUND ART

With respect to ultraviolet rays, electron beams, proton beams, and cosmic rays ($\gamma$-rays and $\alpha$-rays), a glass tends to deteriorate and transmission properties thereof tend to decrease. Therefore, for example, a glass used as a cover glass for a solar cell in space applications is required to have properties of transmitting a spectral sensitivity wavelength range of the solar cell, shielding ultraviolet rays, electron beams, proton beams, and cosmic rays, and not decreasing the transmission properties due to them. For example, Patent Literature 1 discloses a glass containing $CeO_2$ as a component that absorbs ultraviolet rays.

CITATION LIST

PATENT LITERATURE

Patent Literature 1: JP2006-264994A

SUMMARY OF INVENTION

TECHNICAL PROBLEM

In the cover glass for a solar cell, it is desirable to increase a transmittance at a wavelength of 300 nm to 1100 nm in order to increase power generation efficiency of the solar cell. On the other hand, since ultraviolet rays lead to deterioration of resins and solar cells, it is necessary to provide a design having electron-beam resistance, ultraviolet-ray resistance, and light transmission to sufficiently obtain an effect of shielding ultraviolet rays. However, in the case where $CeO_2$ is contained in the glass as in the glass described in Patent Literature 1, there is a problem that UV light can be shielded up to a wavelength of 340 nm, but light having a longer wavelength is difficult to be shielded.
In addition, as properties newly required for the cover glass for a solar cell, it is required to increase the size of the solar cell. However, there is a problem that the strength decreases by increasing the size of the glass.
Therefore, an object of the present invention is to provide a glass having excellent electron-beam resistance and effect of shielding ultraviolet rays and having an excellent strength, as compared with those in the related art.

SOLUTION TO PROBLEM

The inventors of the present invention have found that the above problems can be solved by setting a composition of a glass to a specific range, and have completed the present invention. That is, the present invention is as follows.

    1. A glass containing, in terms of mass% based on oxides:

        0.3% to 10% of $CeO_2$;
        45% to 85% of $SiO_2$; and
        0% to 25% of $Al_2O_3$.

    2. The glass according to the above 1, containing, in terms of mass% based on oxides:

        2.0% to 10% of $CeO_2$;
        45% to 85% of $SiO_2$; and
        0% to 7% of $Al_2O_3$.

    3. The glass according to the above 1, containing, in terms of mass% based on oxides: 7.0% to 25% of $Al_2O_3$.
    4. The glass according to any one of the above 1 to 3, further containing, in terms of mass% based on oxides: 0.3% to 3.0% of $Fe_2O_3$.

5. The glass according to any one of the above 1 to 3, in which the content of $CeO_2$ is 6.0% or more in terms of mass% based on oxides.

6. The glass according to any one of the above 1 to 3, further containing, in terms of mass% based on oxides: 10% or less of $B_2O_3$.

7. The glass according to any one of the above 1 to 3, further containing at least one of $Na_2O$, $K_2O$, and $Li_2O$, in which the glass has a total content $R_2O$ of $Na_2O$, $K_2O$, and $Li_2O$ of 7% to 25% in terms of mass% based on oxides.

8. The glass according to any one of the above 1 to 3, being substantially free of BaO.

9. The glass according to any one of the above 1 to 3, having a content of NiO of 0.08% or less in terms of mass% based on oxides.

10. The glass according to any one of the above 1 to 3, further containing, in terms of mass% based on oxides: 0% to 0.8% of $TiO_2$.

11. The glass according to any one of the above 1 to 3, further containing, in terms of mass% based on oxides: 0% to 0.1% of $TiO_2$.

12. The glass according to any one of the above 1 to 3, having a thickness of 0.2 mm or less.

13. The glass according to any one of the above 1 to 3, having a rectangle shape that has a main surface having one side of 50 cm or more and 300 cm or less.

14. The glass according to any one of the above 1 to 3, having a visible light average transmittance of 80% or more after being irradiated with an electron beam of $1 \times 10^{15}$ electrons/cm$^2$ at an energy amount of 1 MeV.

15. The glass according to any one of the above 1 to 3, having an average thermal expansion coefficient at 50°C to 350°C of $20 \times 10^{-7}$/°C to $100 \times 10^{-7}$/°C.

16. The glass according to any one of the above 1 to 3, being chemically strengthenable.

17. The glass according to any one of the above 1 to 3, being a cover glass for a solar cell.

18. The glass according to any one of the above 1 to 3, being a glass for cutting an electron beam.

19. The glass according to any one of the above 1 to 3, being a glass for cutting an ultraviolet ray.

ADVANTAGEOUS EFFECTS OF INVENTION

Since the glass according to the present invention has a specific composition, the glass has excellent electron-beam resistance and effect of shielding ultraviolet rays, has an excellent strength, and can be increased in size, as compared with those in the related art. Due to such properties, the glass according to the present invention is suitable as a cover glass for a solar cell.

DESCRIPTION OF EMBODIMENTS

Hereinafter, the present invention is described in detail, but the present invention is not limited to the following embodiment, and can be freely modified and implemented without departing from the gist of the present invention. In the present description, "to" indicating a numerical range is used in the sense of including the numerical values set forth before and after the "to" as a lower limit value and an upper limit value, and unless otherwise specified, "to" is used hereinafter with the same meaning.

In the present description, "being substantially free of" a certain component means that the component is not contained except for inevitable impurities mixed from raw materials and the like. That is, it means that it is not intentionally contained.

Specifically, it means that the content in a glass composition is less than 0.1 mass%.

<Glass>

<<Composition>>

A glass according to the present embodiment contains, in terms of mass% based on oxides, 0.3% to 10% of $CeO_2$, 45% to 85% of $SiO_2$, and 0% to 25% of $Al_2O_3$. Hereinafter, the composition of the glass according to the present invention is described using the content in mass% unless otherwise specified.

One embodiment of the present invention includes a mode containing 2.0% to 10% of $CeO_2$, 45% to 85% of $SiO_2$, and 0% to 7% of $Al_2O_3$ (hereinafter, such a mode is referred to as a "glass $X_a$").

Another embodiment of the present invention includes a mode containing 0.4% to 10% of $CeO_2$, 45% to 85% of $SiO_2$, and 7% to 25% of $Al_2O_3$ (hereinafter, such a mode is referred to as a "glass $X_b$").

Still another embodiment of the present invention includes a mode containing 0.3% to 10% of $CeO_2$, 45% to 85% of $SiO_2$, and 2.0% to 10% of $Al_2O_3$ (hereinafter, such a mode is referred to as a "glass $X_c$").

$CeO_2$ is a component that improves an effect of shielding ultraviolet rays and that prevents coloration due to an electron beam, and is essential. The content of $CeO_2$ is 0.3% or more, preferably 0.4% or more, more preferably 0.6% or more, still more preferably 0.8% or more, and particularly preferably 1.0% or more, 1.2% or more, 1.5% or more, 2.0% or more, 3.0% or more, 4.0% or more, 5.0% or more, 6.0% or more, and 7.0% or more in this order. In addition, the content of $CeO_2$ is 10.0% or less, preferably 9.5% or less, more preferably 9.0% or less, still more preferably 8.5% or less, even more preferably 8.0% or less, and particularly preferably 7.5% or less.

When the content of $CeO_2$ is 0.4% or more, the coloration of the glass due to an electron beam and the effect of shielding ultraviolet rays can be sufficiently ensured. In particular, when the content of $CeO_2$ is 6.0% or more, the effect of shielding ultraviolet rays can be further improved at a wavelength having a transmittance of 2%. When the content of $CeO_2$ is 10.0% or less, devitrification can be prevented.

In the glass $X_b$, the content of $CeO_2$ is preferably 9.0% or less, more preferably 8.0% or less, still more preferably 7.0% or less, particularly preferably 5.0% or less, and most preferably 3.0% or less.

$SiO_2$ is a component that constitutes a glass framework, and is essential. The content of $SiO_2$ is 45% or more, preferably 48% or more, more preferably 50% or more, still more preferably 55% or more, and particularly preferably 60% or more. In addition, the content of $SiO_2$ is 85% or less, preferably 80% or less, more preferably 75% or less, still more preferably 73% or less, and particularly preferably 70% or less. When the content of $SiO_2$ is 45% or more, chemical durability can be improved. When the content of $SiO_2$ is 85% or less, an increase in $T_2$ or $T_4$ can be prevented, and meltability or moldability of the glass can be improved.

$Al_2O_3$ is a component that improves mechanical properties such as a Young's modulus and a fracture toughness value of the glass and that improves ion exchange performance and weather resistance. In the case where $Al_2O_3$ is contained, it is preferably 1.0% or more, more preferably 2.0% or more, still more preferably 4.0% or more, and particularly preferably 5.0% or more, 5.5% or more, 6.0% or more, 6.5% or more, 7.0% or more, 7.5% or more, 8.0% or more, and 9.0% or more in this order. In addition, the content of $Al_2O_3$ is 25% or less, more preferably 24% or less, still more preferably 23% or less, and particularly preferably 22% or less, 20% or less, 18% or less, 17% or less, 15% or less, 13% or less, 11% or less, and 10% or less in this order. When $Al_2O_3$ is 25% or less, an increase in $T_2$ or $T_4$ can be prevented, and the meltability or the moldability of the glass can be improved. In addition, in the case of being added together with $CeO_2$, $Al_2O_3$ is also a component that deteriorates a devitrification property.

In the glass $X_a$, when $Al_2O_3$ is 0% to 7%, it is possible to further increase the strength required with an increase in size of the glass. In the case where the glass $X_a$ contains $Al_2O_3$, the content thereof is preferably 7% or less, more preferably 5% or less, still more preferably 4% or less, and particularly preferably 3% or less and 2% or less in this order. In addition, in the case where the glass $X_a$ contains $Al_2O_3$, the content thereof is preferably 0.5% or more, more preferably 1.0% or more, and still more preferably 1.5% or more.

When the content of $Al_2O_3$ in the glass $X_b$ is 7.0% to 25%, chemical strengthening properties can be further improved.

When the content of $Al_2O_3$ in the glass $X_C$ is 2.0% to 10%, the chemical strengthening properties can be further improved.

A total content $(SiO_2+Al_2O_3)$ of $SiO_2$ and $Al_2O_3$ is preferably 65% or more, more preferably 67% or more, still more preferably 70% or more, and particularly preferably 72% or more. When $(SiO_2+Al_2O_3)$ is 65% or more, the strength can be further increased. From the viewpoint of further improving the meltability and the moldability of the glass, $(SiO_2+Al_2O_3)$ is preferably 85% or less, more preferably 80% or less, and still more preferably 75% or less.

In the glass $X_a$, $(SiO_2+Al_2O_3)$ is preferably 68% or more and 75% or less, more preferably 70% or more and 74% or less, and still more preferably 71% or more and 73% or less.

In the glass $X_b$, $(SiO_2+Al_2O_3)$ is preferably 65% or more and 80% or less, more preferably 70% or more and 78% or less, and still more preferably 72% or more and 77% or less.

In the glass $X_C$, $(SiO_2+Al_2O_3)$ is preferably 68% or more and 75% or less, more preferably 70% or more and 74% or less, and still more preferably 71% or more and 73% or less.

A total content $(CeO_2+SiO_2+Al_2O_3)$ of $CeO_2$, $SiO_2$, and $Al_2O_3$ is preferably 71% or more, more preferably 72% or more, still more preferably 73% or more, and particularly preferably 74% or more, from the viewpoint of increasing a devitrification viscosity while maintaining an ultraviolet-ray shielding property. In addition, $(CeO_2+SiO_2+Al_2O_3)$ is preferably 87% or less, more preferably 82% or less, still more preferably 80% or less, and particularly preferably 77% or less, from the viewpoint of improving melting properties from batch of glass to vitrification for the glass.

$Fe_2O_3$ is an optional component, but is preferably contained from the viewpoint of improving the effect of shielding ultraviolet rays and preventing coloration due to an electron beam. In the case where $Fe_2O_3$ is contained, the content thereof is preferably 0.01% or more, more preferably 0.05% or more, 0.1% or more, 0.2% or more, and 0.3% or more in this order, still more preferably 0.5% or more, even more preferably 0.7% or more, and particularly preferably 0.8% or more. In addition, the content of $Fe_2O_3$ is preferably 3.0% or less, more preferably 2.0% or less, still more preferably 1.5% or less, particularly preferably 1.0% or less, and most preferably 0.85% or less. When the content of $Fe_2O_3$ is 0.3% or more, the effect of shielding ultraviolet rays can be sufficiently ensured, and the coloration due to an electron beam can be further prevented. When the content of $Fe_2O_3$ is 3.0% or less, a visible light transmittance can be more than 87%.

**In** one embodiment of the present invention, in the case (glass $X_a$) where the glass contains 2.0% to 10% of $CeO_2$, 45% to 85% of $SiO_2$, and 0% to 7% of $Al_2O_3$, a total content ($CeO_2+Al_2O_3+Fe_2O_3$) of $CeO_2$, $Al_2O_3$, and $Fe_2O_3$ is preferably 3.0% or more, more preferably 3.5% or more, still more preferably 4.0% or more, and particularly preferably 4.5% or more, from the viewpoint of achieving both the ultraviolet-ray shielding property and the mechanical properties. **In** addition, in such a mode (glass $X_a$), ($CeO_2+Al_2O_3+Fe_2O_3$) is preferably 10% or less, more preferably 9% or less, still more preferably 8% or less, and particularly preferably 7% or less, from the viewpoint of lowering a devitrification temperature.

**In** another embodiment of the present invention, in the case (glass $X_b$) where the glass contains 0.4% to 10% of $CeO_2$, 45% to 85% of $SiO_2$, and 7% to 25% of $Al_2O_3$, the total content ($CeO_2+Al_2O_3+Fe_2O_3$) of $CeO_2$, $Al_2O_3$, and $Fe_2O_3$ is preferably 10% or more, more preferably 12% or more, still more preferably 13% or more, particularly preferably 14% or more, and most preferably 15% or more, from the viewpoint of achieving both the ultraviolet-ray shielding property and the mechanical properties. **In** addition, in such a ,mode (glass $X_b$), ($CeO_2+Al_2O_3+Fe_2O_3$) is preferably 22% or less, more preferably 20% or less, still more preferably 18% or less, and particularly preferably 16% or less, from the viewpoint of lowering the devitrification temperature.

**In** still another embodiment of the present invention, in the case (glass $X_c$) where the glass contains 0.3% to 10% of $CeO_2$, 45% to 85% of $SiO_2$, and 2.0% to 10% of $Al_2O_3$, the total content ($CeO_2+Al_2O_3+Fe_2O_3$) of $CeO_2$, $Al_2O_3$, and $Fe_2O_3$ is preferably 5.0% or more, more preferably 5.5% or more, still more preferably 6.0% or more, particularly preferably 6.5% or more, and most preferably 7.0% or more, from the viewpoint of achieving both the ultraviolet-ray shielding property and the mechanical properties. **In** addition, in such a mode (glass $X_c$), ($CeO_2+Al_2O_3+Fe_2O_3$) is preferably 11.0% or less, more preferably 10.0% or less, still more preferably 9.0% or less, and particularly preferably 8.0% or less, from the viewpoint of lowering the devitrification temperature.

**In** one embodiment of the present invention, in the case (glass $X_a$) where the glass contains 2.0% to 10% of $CeO_2$, 45% to 85% of $SiO_2$, and 0% to 7% of $Al_2O_3$, a value of X represented by the following equation 1 is preferably 2 or more, more preferably 3 or more, still more preferably 4 or more, and particularly preferably 6 or more, from the viewpoint of achieving both the ultraviolet-ray shielding property and the mechanical properties. In addition, in such a mode (glass $X_a$), the value of X represented by the following equation 1 is preferably 10 or less, more preferably 9 or less, still more preferably 8 or less, and particularly preferably 7 or less, from the viewpoint of lowering the devitrification temperature.

$$\text{(Equation 1)} \qquad X = [CeO_2]+1/2\times[Al_2O_3]+[Fe_2O_3]$$

In the equation 1, the parenthesis [] represents the content in terms of mass% based on oxides.

**In** another embodiment of the present invention, in the case (glass $X_b$) where the glass contains 0.4% to 10% of $CeO_2$, 45% to 85% of $SiO_2$, and 7% to 25% of $Al_2O_3$, the value of X represented by the above equation 1 is preferably 5 or more, more preferably 6 or more, still more preferably 7 or more, particularly preferably 8 or more, and most preferably 9 or more, from the viewpoint of achieving both the ultraviolet-ray shielding property and the mechanical properties. In addition, in such a mode (glass $X_b$), the value of X represented by the following equation 1 is preferably 13 or less, more preferably 12 or less, still more preferably 11 or less, and particularly preferably 10 or less, from the viewpoint of lowering the devitrification temperature.

**In** still another embodiment of the present invention, in the case (glass $X_c$) where the glass contains 0.3% to 10% of $CeO_2$, 45% to 85% of $SiO_2$, and 2.0% to 10% of $Al_2O_3$, the value of X represented by the above equation 1 is preferably 3.0 or more, more preferably 3.5 or more, still more preferably 4.0 or more, and particularly preferably 4.5 or more, from the viewpoint of achieving both the ultraviolet-ray shielding property and the mechanical properties. In addition, in such a mode (glass $X_c$), the value of X represented by the following equation 1 is preferably 8.0 or less, more preferably 7.0 or less, still more preferably 6.0 or less, and particularly preferably 5.0 or less, from the viewpoint of lowering the devitrification temperature.

$B_2O_3$ may be contained in order to improve the meltability at a high temperature or the glass strength. On the other hand, when the content of $B_2O_3$ is large, the Young's modulus decreases, the fracture toughness decreases, and the strength tends to decrease. In addition, acid resistance of the glass may deteriorate, or the glass may easily undergo phase separation and lose transparency, making it difficult to obtain a homogeneous glass, and the moldability of the glass may decrease. Therefore, in the case where $B_2O_3$ is contained, the content thereof is preferably 10% or less, more preferably 8% or less, still more preferably 6% or less, particularly preferably 5% or less, 4% or less, 3% or less, 2% or less, 1% or less, and 0.5% in this order, and most preferably 0%.

$Na_2O$ is an optional component that forms a surface compressive stress layer by ion exchange or that improves the meltability of the glass, and may be contained. In the case where $Na_2O$ is contained, the content thereof is preferably 5.0% or more, more preferably 7.0% or more, still more preferably 8.0% or more, and particularly preferably 9.0% or more, 9.5% or more, 10.0% or more, 10.5% or more, 11.0% or more, and 11.5% or more in this order. In addition, the content of $Na_2O$ is preferably 20.0% or less, more preferably 19.0% or less, 18.0% or less, and 17.0% or less in this order, still more preferably 16.5% or less, even more preferably 16.0% or less, particularly preferably 15.8% or less, and most preferably 15.5% or less. When the content of $Na_2O$ is 5.0% or more, a desired surface compressive stress layer is easily formed by ion exchange. In addition, when the content of $Na_2O$ is 20.0% or less, a decrease in weather resistance or a decrease in strength can be prevented.

$K_2O$ is not essential and is an optional component that increases an ion exchange rate. In the case where $K_2O$ is contained, the content thereof is preferably 0.1% or more, more preferably 1% or more, still more preferably 3% or more, and particularly preferably 5% or more. The content of $K_2O$ is preferably 8.0% or less, more preferably 7.0% or less, still more preferably 6.5% or less, even more preferably 6.0% or less, particularly preferably 5.0% or less, and most preferably 4.0% or more. When the content of $K_2O$ is 8.0% or less, a decrease in strength can be prevented.

In the glass according to the present embodiment, a total content $(Na_2O+K_2O)$ of $Na_2O$ and $K_2O$ is preferably 22% or less, more preferably 21% or less, still more preferably 20% or less, particularly preferably 19% or less, and most preferably 18% or less. In addition, $(Na_2O+K_2O)$ is preferably 13% or more, more preferably 14% or more, still more preferably 15% or more, particularly preferably 15.5% or more, and most preferably 16% or more. When $(Na_2O+K_2O)$ is 22% or less, a decrease in weather resistance or a decrease in strength can be prevented.

$Li_2O$ is an optional component that increases the Young's modulus and the fracture toughness value of the glass, that improves the mechanical properties, and that forms a surface compressive stress by ion exchange. In the case where $Li_2O$ is contained, the content thereof is preferably 0.1% or more, more preferably 3% or more, still more preferably 5% or more, and particularly preferably 7% or more. When the content of $Li_2O$ is 20% or less, a stable surface compressive stress layer can be easily obtained by preventing a decrease in strain point and preventing stress relaxation, and a remarkable decrease in acid resistance of the glass can be prevented.

The glass according to the present embodiment may contain at least one of $Na_2O$, $K_2O$, and $Li_2O$ from the viewpoint of improving the chemical strengthening properties. In the case where at least one of $Na_2O$, $K_2O$, and $Li_2O$ is contained, the total content $R_2O$ is preferably 7% or more, more preferably 8% or more, still more preferably 9% or more, particularly preferably 10% or more, and most preferably 13% or more. In the glass according to the present embodiment, when $R_2O$ is 7% or more, the viscosity of the glass can be reduced to such an extent that continuous production is possible. In the glass according to the present embodiment, $R_2O$ is preferably 25% or less, more preferably 22% or less, still more preferably 20% or less, and particularly preferably 18% or less. In the glass according to the present embodiment, when $R_2O$ is 25% or less, sufficient weather resistance is obtained.

MgO is a component that may decrease the ion exchange rate, and is an optional component that prevents a decrease in strength or improves the meltability. In the case where MgO is contained, the content thereof is preferably 3.5% or more, more preferably 4.0% or more, still more preferably 5.0% or more, and particularly preferably 6.0% or more. The content of MgO is preferably 13.0% or less, more preferably 12.5% or less, still more preferably 12.0% or less, and particularly preferably 11.5% or less, 11.0% or less, 10.5% or less, 10.0% or less, 9.5% or less, 9.0% or less, 8.5% or less, 8.0% or less, 7.5% or less, and 7.0% or less in this order.

A total content $(Na_2O+MgO)$ of $Na_2O$ and MgO is preferably 15.0% or more, more preferably 16.0% or more, still more preferably 17.0% or more, particularly preferably 17.5% or more, and most preferably 18.0% or more. $(Na_2O+MgO)$ is preferably 25% or less, more preferably 24% or less, still preferably 22% or less, and particularly preferably 21% or less. When $(Na_2O+MgO)$ is 15.0% or more, an increase in $T_2$ or $T_4$ is prevented, and the meltability or the moldability of the glass can be improved. In addition, when $(Na_2O+MgO)$ is 25% or less, a decrease in strength can be prevented.

BaO may be contained in order to improve the meltability at a high temperature or make devitrification less likely to occur, but it is preferable that the glass is substantially free of BaO since the ion exchange rate may decrease. In the case where BaO is contained, the content thereof is preferably 1.0% or less, more preferably 0.5% or less, and still more preferably 0.1% or less.

CaO and SrO may be contained in order to improve the meltability at a high temperature or make devitrification less likely to occur, but it is preferable that the glass is substantially free of CaO and SrO since the ion exchange rate may decrease. In the case where CaO is contained, the content thereof is preferably 8% or less, more preferably 6% or less, still more preferably 4% or less, and particularly preferably 2% or less.

SrO may be contained in order to improve the meltability at a high temperature or make devitrification less likely to occur, but it is preferable that the glass is substantially free of SrO since the ion exchange rate may decrease. In the case where SrO is contained, the content thereof is preferably 1.0% or less, more preferably 0.5% or less, and still more preferably 0.1% or less.

When at least one of BaO, CaO, and SrO is contained, a total content of these three components is preferably 1.0% or less, and more preferably 0.5% or less.

From the viewpoint of increasing a transmittance at a wavelength of 300 nm to 1100 nm and improving the power generation efficiency of the solar cell, it is preferable that the glass is substantially free of NiO. In the case where NiO is contained, the content thereof is preferably 1.0% or less, more preferably 0.5% or less, still more preferably 0.1% or less, and particularly preferably 0.08% or less.

$TiO_2$ may be contained because of having an excellent effect of preventing solarization cause by UVC. In the case where $TiO_2$ is contained, the content thereof is preferably 1.5% or less, more preferably 1.0% or less, 0.9% or less, 0.8% or less, 0.75% or less, 0.7% or less, 0.6% or less, 0.5% or less, and 0.1% or less in this order, still more preferably 0.05% or less, and even more preferably 0.01% or less, from the viewpoint of preventing solarization cause by UVC and preventing the coloration of the glass. $TiO_2$ is preferably 0.001% or more.

$ZrO_2$ is not an essential component, but may be contained in a range of 5.0% or less in order to decrease the viscosity at a high temperature or increase the surface compressive stress. When the content of $ZrO_2$ is 5.0% or less, a decrease in strength can be prevented. The content is preferably 5.0% or less, more preferably 4.0% or less, 3.0% or less, 2.0% or less, 1.5% or less, and 1.4% or less in this order, still more preferably 1.3% or less, and particularly preferably 1.1% or less.

ZnO may be contained in order to improve the meltability of the glass at a high temperature, and in this case, the content thereof is preferably 1.0% or less, more preferably 0.5% or less, and still more preferably 0.25% or less. In the case of producing the glass by using a float method, the content of ZnO is preferably 0.5% or less, more preferably 0.25% or less, and the glass is still more preferably substantially free of ZnO, and the content of ZnO is most preferably 0%. When the content of ZnO is 0.5% or less, reduction during float molding can be prevented, and generation of product defects can be prevented.

$V_2O_5$ may be contained in order to improve the effect of shielding ultraviolet rays. In the case where $V_2O_5$ is contained, the content thereof is preferably 0.01% or more, more preferably 0.05% or more, still more preferably 0.1% or more, and particularly preferably 0.2% or more, from the viewpoint of further improving the effect of shielding ultraviolet rays. On the other hand, in the case where $V_2O_5$ is contained, the content thereof is preferably 1.0% or less, more preferably 0.8% or less, still more preferably 0.6% or less, and particularly preferably 0.4% or less, from the viewpoint of preventing the coloration.

$SO_3$, a chloride, and a fluoride may be appropriately contained as a refining agent during melting of the glass. However, in order to improve the power generation efficiency of the solar cell in the case of using with a cover glass for a solar cell, it is preferable to reduce the amount of components such as $Cr_2O_3$ having absorption in a wavelength region of 300 nm to 1100 nm mixed as impurities in the raw material as much as possible, and in the case of containing the component, it is preferably 0.15% or less, more preferably 0.1% or less, and particularly preferably 0.05% or less.

Specific examples of the composition of the glass according to the present embodiment include the following.

(1) A glass containing, in terms of mass% based on oxides, 0.4% to 10.0% of $CeO_2$, 45% to 85% of $SiO_2$, 7.0% to 25% of $Al_2O_3$, 0.1% to 2% of $Fe_2O_3$, 0% to 10.0% of MgO, 0% to 20.0% of $Na_2O$, 0% to 8.0% of $K_2O$, 10% or less of $B_2O_3$ (in the case of being contained), 5.0% or less of $ZrO_2$ (in the case of being contained), 1.5% or less of $TiO_2$ (in the case of being contained), and 3% or less of CaO (in the case of being contained).

(2) A glass containing, in terms of mass% based on oxides, 2.0% to 10.0% of $CeO_2$, 45% to 85% of $SiO_2$, 0% to 7% of $Al_2O_3$, 0% to 1.0% of $Fe_2O_3$, 0% to 10.0% of MgO, 0% to 20.0% of $Na_2O$, 0% to 4.0% of $K_2O$, 10% or less of $B_2O_3$ (in the case of being contained), 2% or less of $ZrO_2$ (in the case of being contained), 0.1% or less of $TiO_2$ (in the case of being contained), and 10.0% or less of CaO (in the case of being contained).

(3) A glass containing, in terms of mass% based on oxides, 0.4% to 2.0% of $CeO_2$, 45% to 85% of $SiO_2$, 0% to 7% of $Al_2O_3$, 0.5% to 2.0% of $Fe_2O_3$, 0% to 10.0% of MgO, 0% to 20.0% of $Na_2O$, 0% to 4.0% of $K_2O$, 10% or less of $B_2O_3$ (in the case of being contained), 2.0% or less of $ZrO_2$ (in the case of being contained), 0.1% or less of $TiO_2$ (in the case of being contained), and 10% or less of CaO (in the case of being contained).

(4) A glass containing, in terms of mass% based on oxides, 2.0% to 10.0% of $CeO_2$, 45% to 85% of $SiO_2$, 6.0% to 15% of $Al_2O_3$, 0.1% to 1.8% of $Fe_2O_3$, 0% to 10.0% of MgO, 0% to 20.0% of $Na_2O$, 0% to 5.0% of $K_2O$, 10% or less of $B_2O_3$ (in the case of being contained), 3.0% or less of $ZrO_2$ (in the case of being contained), 1.0% or less of $TiO_2$ (in the case of being contained), and 6% or less of CaO (in the case of being contained).

<<Other Properties>>

The glass according to the present embodiment has a thickness of preferably 0.2 mm or less, more preferably 0.15 mm or less, and particularly preferably 0.1 mm or less. In particular, in space applications, the thickness is preferably 0.2 mm or less from the viewpoint of weight reduction. The thickness is not particularly limited in lower limit, and is preferably 0.03 mm or more, and more preferably 0.05 mm or more, or 0.07 mm or more, from the viewpoint of ensuring the strength and sufficiently shielding the electron beam and the proton beam.

The glass according to the present embodiment is not particularly limited in shape, and is preferably a rectangular plate or sheet. The size of a cover glass for satellite (for space) that has been used so far is generally about 10 cm in one side. A length of one side of a main surface in the case of a rectangle is preferably 20 cm or more, 30 cm or more, 40 cm or more, and 50 cm or more in this order, more preferably 70 cm or more, 80 cm or more, and 90 cm or more in this order, still more preferably 100 cm or more, and 120 cm or more in this order, and particularly preferably 150 cm or more, from the viewpoint of increasing the size. Since the glass according to the present embodiment has the above specific composition range, the strength can be ensured even in the case where the size is increased. In addition, the length of one side of the main surface in the case of a rectangle is usually preferably 400 cm or less, 350 cm or less, more preferably 300 cm or less, still more preferably 250 cm or less, and particularly preferably 200 cm or less, from the viewpoint of handling a thin glass without cracks.

The glass according to the present embodiment has an average transmittance at a wavelength of 380 nm to 780 nm of preferably 89% or more, more preferably 90% or more, still more preferably 90.5% or more, and particularly preferably 91% or more. When the average transmittance at a wavelength of 380 nm to 780 nm is 89% or more, the power generation properties of the solar cell can be further improved in the case where the glass is used as a cover glass for a solar cell.

The glass according to the present embodiment has a wavelength at which the transmittance is 2% of preferably 270 nm or more, and more preferably 270 nm or more, 290 nm or more, 310 nm or more, 330 nm or more, and 350 nm or more in this order. The wavelength at which the transmittance is 2% is preferably 400 nm or less, more preferably 390 nm or less, still more preferably 380 nm or less, and particularly preferably 370 nm or less. When the wavelength at which the transmittance is 2% is 270 nm or more, the effect of shielding ultraviolet rays can be further improved. When the wavelength at which the transmittance is 2% is 400 nm or less, spectral sensitivity of the solar cell in the case where the glass is used as a cover glass for a solar cell can be improved, and the power generation efficiency can be improved.

The glass according to the present embodiment has a visible light average transmittance of preferably 70% or more, more preferably 80% or more, still more preferably 83% or more in this order, even more preferably 85% or more, and particularly preferably 88% or more, after a glass having a thickness of 0.1 mm is irradiated with an electron beam of $1 \times 10^{15}$ electrons/cm$^2$ at an energy amount of 1 MeV. When the visible light average transmittance is particularly 80% or more, deterioration of solar cell properties due to the electron beam can be effectively prevented, for example, in space applications. The visible light average transmittance is not particularly limited in upper limit, and is usually preferably 93% or less in consideration that a glass for shielding an electron beam is substantially present.

The glass according to the present embodiment has a visible light average transmittance of preferably 80% or more, more preferably 83% or more, still more preferably 85% or more, and particularly preferably 88% or more, after irradiation with ultraviolet rays having a wavelength of 254 nm at 22500 mJ/cm$^2$. When the visible light average transmittance after irradiation with ultraviolet rays having a wavelength of 254 nm at 22500 mJ/cm$^2$ is 80% or more, deterioration of a resin for fixing the solar cell due to UV can be effectively prevented, particularly in the case where the glass is used for a cover glass for a solar cell. The visible light average transmittance after the ultraviolet ray irradiation is not particularly limited in upper limit, and is usually preferably 93% or less in consideration that a glass for shielding an electron beam is substantially present.

The glass according to the present embodiment has an average thermal expansion coefficient at 50°C to 350°C of preferably $10 \times 10^{-7}$/°C or more, more preferably $20 \times 10^{-7}$/°C or more, $30 \times 10^{-7}$/°C or more, $40 \times 10^{-7}$/°C or more, $50 \times 10^{-7}$/°C or more, and $60 \times 10^{-7}$/°C or more in this order, still more preferably $65 \times 10^{-7}$/°C or more, and particularly preferably $70 \times 10^{-7}$/°C or more, from the viewpoint of improving adhesiveness to a resin and thermal shock resistance. In addition, the average thermal expansion coefficient at 50°C to 350°C is preferably $100 \times 10^{-7}$/°C or less, more preferably $90 \times 10^{-7}$/°C or less, still more preferably $80 \times 10^{-7}$/°C or less, and particularly preferably $75 \times 10^{-7}$/°C or less.

The glass according to the present embodiment has an average thermal expansion coefficient at 50°C to 350°C of preferably $20 \times 10^{-7}$/°C or more, more preferably $30 \times 10^{-7}$/°C or more, still more preferably $40 \times 10^{-7}$/°C or more, and particularly preferably $50 \times 10^{-7}$/°C or more, particularly from the viewpoint of improving the adhesiveness to a resin. In addition, the average thermal expansion coefficient at 50°C to 350°C is preferably $100 \times 10^{-7}$/°C or less, more preferably $80 \times 10^{-7}$/°C or less, still more preferably $70 \times 10^{-7}$/°C or less, and particularly preferably $60 \times 10^{-7}$/°C or less, particularly from the viewpoint of improving the adhesiveness to a resin.

When the average thermal expansion coefficient at 50°C to 350°C is $20 \times 10^{-7}$/°C or more, the thermal shock resistance can be improved. In particular, when the average thermal expansion coefficient is $70 \times 10^{-7}$/°C or more, it is possible to match thermal expansion properties of the resin used in the solar cell and to improve the solar cell properties. When the average thermal expansion coefficient is $100 \times 10^{-7}$/°C or less, it is possible to match the thermal expansion properties of the resin used in the solar cell and to improve the solar cell properties.

The glass according to the present embodiment has an average thermal expansion coefficient at 50°C to 350°C of preferably $10 \times 10^{-7}$/°C or more and $40 \times 10^{-7}$/°C or less, more preferably $15 \times 10^{-7}$/°C or more and $35 \times 10^{-7}$/°C or less, and still more preferably $20 \times 10^{-7}$/°C or more and $30 \times 10^{-7}$/°C or less, particularly from the viewpoint of improving the thermal shock resistance. When the average thermal expansion coefficient at 50°C to 350°C is $10 \times 10^{-7}$/°C or more and is within the above range, the thermal shock resistance is particularly improved, deterioration of the glass is prevented in space applications, and the power generation properties of the solar cell can be improved.

The glass according to the present embodiment is preferably chemically strengthenable. In the present description, "chemically strengthenable" means that a surface compressive stress layer is formed by a chemical strengthening treatment.

The surface compressive stress and a compressive stress layer depth obtained by chemical strengthening depend on the thickness of the glass. Here, the surface compressive stress and the compressive stress layer depth obtained when a glass having a thickness of 0.5 mm is subjected to a chemical strengthening treatment are described.

Specifically, properties obtained by the chemical strengthening treatment include, for example, a surface compressive stress of preferably 500 MPa or more, more preferably 600 MPa or more, 700 MPa or more, 800 MPa or more, and 900 MPa or more in this order, and still more preferably 1000 MPa or more, which is obtained when a glass having the thickness is subjected to a chemical strengthening treatment at 425°C for 6 hours using a 100 mass% $KNO_3$ salt. The compressive stress layer depth obtained by the chemical strengthening treatment under the above conditions is preferably 5 $\mu$m or more, more preferably 10 $\mu$m or more, still more preferably 20 $\mu$m or more, and 30 $\mu$m or more in this order, and particularly preferably 40 $\mu$m or more. When the surface compressive stress obtained by the chemical strengthening under the above conditions is 600 MPa or more, the strength can be sufficiently ensured even in the case where the glass is increased in size (specifically, for example, in the case where the length of one side is 50 cm or more).

In the glass according to the present embodiment, in the case of using float molding as a molding method, a devitrification viscosity $\eta$ is preferably log $\eta$ = 3 [dPa·s] or more, more preferably log $\eta$ = 3.5 [dPa·s] or more, still more preferably log $\eta$ = 4 [dPa·s] or more, and particularly preferably log $\eta$ = 5 [dPa·s] or more, from the viewpoint of improving productivity. The devitrification viscosity $\eta$ is a viscosity value at a devitrification temperature. The devitrification viscosity is not particularly limited in upper limit, and is usually preferably log $\eta$ = 2 [dPa·s] or less.

The acid resistance of the glass according to the present embodiment is preferably 0.3 mg/cm$^2$ or less, more preferably 0.2 mg/cm$^2$ or less, still more preferably 0.1 mg/cm$^2$ or less, even more preferably 0.05 mg/cm$^2$ or less, particularly preferably 0.04 mg/cm$^2$ or less, and most preferably 0.01 mg/cm$^2$ or less, as calculated by the following method.

Method for evaluating acid resistance: a glass is made into a rectangular glass plate having a rectangle shape that has one side of 40 mm $\pm$ 0.5 mm and having a thickness of 0.4 mm to 1.0 mm, the glass sample is immersed in an acid aqueous solution (a 90°C aqueous solution containing 0.1 mol/l HCl) for 20 hours, and an elution amount (mg/cm$^2$) of the glass component per unit surface area is calculated as the acid resistance.

The glass according to the present embodiment has a temperature ($T_2$) at which the viscosity log $\eta$ is 2 (poise) of preferably 1650°C or lower, more preferably 1600°C or lower, and still more preferably 1550°C or lower, from the viewpoint of reducing the viscosity and improving the productivity, and from the viewpoint of SDGs. The $T_2$ is generally 1400°C or higher.

The glass according to the present embodiment has a temperature ($T_4$) at which the viscosity log $\eta$ is 4 (poise) of preferably 1300°C or lower, more preferably 1250°C or lower, still more preferably 1200°C or lower, 1150°C or lower, and 1100°C or lower in this order, and most preferably 1050°C or lower, from the viewpoint of reducing the viscosity and improving the productivity, and from the viewpoint of the SDGs. The $T_4$ is generally 800°C or higher.

The glass according to the present embodiment has an average value of flatness (Ra) within 1 $\mu$m $\times$ 1 $\mu$m of preferably 2.0 nm or less, more preferably 1.5 nm or less, still more preferably 1.0 nm or less, and even more preferably 0.8 nm or less, the average value of (Ra) within 1 $\mu$m $\times$ 1 $\mu$m being obtained by cutting five glasses each of 50 mm $\times$ 50 mm from a glass having one side of 50 cm or more at a center and at positions close to four corners and measuring the (Ra) within 1 $\mu$m $\times$ 1 $\mu$m of each glass by using AFM. When the flatness is 2.0 nm or less, it is possible to obtain a strength that makes it less likely to break during handling. The average value of the flatness is preferably 0.2 nm or more, more preferably 0.3 nm or more, still more preferably 0.4 nm or more, and even more preferably 0.5 nm or more in lower limit value, since a certain degree of roughness helps reduce static electricity from interleaving paper between the glass and the glass during handling.

In the glass according to the present embodiment, the Young's modulus is preferably 60 GPa or more, more preferably 70 GPa or more, still more preferably 75 GPa or more, and particularly preferably 80 GPa or more, from the viewpoint of improving the fracture toughness and increasing the strength. On the other hand, the Young's modulus is preferably 105 GPa or less, more preferably 100 GPa or less, still more preferably 95 GPa or less, and particularly preferably 90 GPa or less, from the viewpoint of preventing a decrease in ion diffusion during chemical strengthening. The Young's modulus can be measured, for example, by using an ultrasonic pulse method.

The glass according to the present embodiment has a specific gravity of preferably 2.3 or more, more preferably 2.4 or more, and still more preferably 2.5 or more. When the specific gravity is 2.3 or more, the electron beam and the proton beam are effectively shielded, and deterioration of the solar cell can be prevented particularly in the case where the glass is used as a cover glass for a solar cell. In addition, the specific gravity is preferably 3 or less, more preferably 2.8 or less, and still more preferably 2.6 or less, from the viewpoint of weight reduction. The specific gravity is measured by using the Archimedes method.

<Production Method>

The glass according to the present embodiment can be produced by a general method. For example, raw materials of components of the glass are blended, and then heated and melted in a glass melting furnace. Thereafter, the glass is homogenized by a known method and molded into a desired shape such as a glass plate, followed by annealing.

Examples of a molding method for a glass plate include a float method, a press method, a fusion method, and a down-draw method. Particularly, a float method suitable for mass production is preferred. As a continuous molding method other than the float method, that is, a fusion method and a down-draw method are also preferred.

Thereafter, the molded glass is subjected to a grinding treatment, a polishing treatment, and an etching treatment to form a glass substrate. A thickness of the glass substrate can be adjusted to a desired thickness based on conditions of the treatments. Specific examples of etching include a method of polishing the glass surface by immersing the glass substrate in a solution containing hydrofluoric acid or the like and etching the glass substrate.

The glass substrate may be subjected to a chemical strengthening treatment to be described later. Note that, in the case of cutting the glass substrate into a predetermined shape and size or chamfering the glass substrate, it is preferable to perform cutting or chamfering of the glass substrate before a chemical strengthening treatment to be described later is performed since a compressive stress layer is also formed on an end surface by the subsequent chemical strengthening treatment.

The chemical strengthening treatment is a treatment in which a glass is brought into contact with a metal salt by a method of immersing a glass into a melt of a metal salt (for example, potassium nitrate) containing metal ions having a large ion radius (typically, Na ions or K ions), and thereby metal ions having a small ion radius (typically, Na ions or Li ions) in the glass are substituted with the metal ions having a large ion radius (typically, Na ions or K ions for Li ions, and K ions for Na ions).

In order to increase the rate of the chemical strengthening treatment, it is preferable to use "Li-Na exchange" in which Li ions in the glass are exchanged with Na ions. In addition, in order to form a large compressive stress by ion exchange, it is preferable to use "Na-K exchange" in which Na ions in the glass are exchanged with K ions.

Examples of the molten salt for performing the chemical strengthening treatment include a nitrate, a sulfate, a carbonate, and a chloride. Among them, examples of the nitrate include lithium nitrate, sodium nitrate, potassium nitrate, cesium nitrate, and silver nitrate. Examples of the sulfate include lithium sulfate, sodium sulfate, potassium sulfate, cesium sulfate, and silver sulfate. Examples of the carbonate include lithium carbonate, sodium carbonate, and potassium carbonate. Examples of the chloride include lithium chloride, sodium chloride, potassium chloride, cesium chloride, and silver chloride. These molten salts may be used alone or in combination of plural types thereof.

As treatment conditions of the chemical strengthening treatment, a time, a temperature, and the like can be selected in consideration of a glass composition, a type of the molten salt, and the like. For example, the glass is subjected to a chemical strengthening treatment at preferably 450°C or lower for preferably 1 hour or shorter. Specifically, for example, a treatment of immersing the glass in a molten salt containing 0.3 mass% of Li and 99.7 mass% of Na (for example, a mixed salt containing lithium nitrate and sodium nitrate) at preferably 450°C for preferably about 0.5 hours is exemplified.

The chemical strengthening treatment may be performed by two or more stages of ion exchange. The two-stage ion exchange is specifically performed, for example, as follows. First, a glass for chemical strengthening is immersed in a metal salt (for example, sodium nitrate) containing Na ions at preferably about 350°C to 500°C for preferably about 0.1 hours to 10 hours. This causes ion exchange between Li ions in the glass for chemical strengthening and Na ions in the metal salt, thereby forming a relatively deep compressive stress layer.

<Application>

The glass according to the present embodiment is suitably used as a cover glass for a solar cell, a glass for cutting an electron beam, a glass for cutting an ultraviolet ray, an optical lens for space, an optical member for space, and the like. The glass according to the present embodiment has excellent electron beam resistance and effect of shielding ultraviolet rays, has an excellent strength, and can be increased in size, as compared with those in the related art, and is thus more suitable as a cover glass for a solar cell, an optical lens for space, an optical member for space, and the like, which are required to have these properties.

As described above, the following matters are disclosed in the present description.

1. A glass containing, in terms of mass% based on oxides:

0.3% to 10% of $CeO_2$;
45% to 85% of $SiO_2$; and
0% to 25% of $Al_2O_3$.

2. The glass according to the above 1, containing, in terms of mass% based on oxides:

2.0% to 10% of $CeO_2$;
45% to 85% of $SiO_2$; and
0% to 7% of $Al_2O_3$.

3. The glass according to the above 1, containing, in terms of mass% based on oxides: 7.0% to 25% of $Al_2O_3$.

4. The glass according to any one of the above 1 to 3, further containing, in terms of mass% based on oxides: 0.3% to 3.0% of $Fe_2O_3$.

5. The glass according to any one of the above 1 to 4, in which the content of $CeO_2$ is 6.0% or more in terms of mass% based on oxides.

6. The glass according to any one of the above 1 to 5, further containing, in terms of mass% based on oxides: 10% or less of $B_2O_3$.

7. The glass according to any one of the above 1 to 6, containing at least one of $Na_2O$, $K_2O$, and $Li_2O$, in which a total content $R_2O$ of $Na_2O$, $K_2O$, and $Li_2O$ is 7% to 25% in terms of mass% based on oxides.

8. The glass according to any one of the above 1 to 7, being substantially free of BaO.

9. The glass according to any one of the above 1 to 8, having a content of NiO of 0.08% or less in terms of mass% based on oxides.

10. The glass according to any one of the above 1 to 9, further containing, in terms of mass% based on oxides: 0% to 0.8% of $TiO_2$.

11. The glass according to any one of the above 1 to 10, further containing, in terms of mass% based on oxides: 0% to 0.1% of $TiO_2$.

12. The glass according to any one of the above 1 to 11, having a thickness of 0.2 mm or less.

13. The glass according to any one of the above 1 to 12, having a rectangle shape that has a main surface having one side of 50 cm or more and 300 cm or less.

14. The glass according to any one of the above 1 to 13, having a visible light average transmittance of 80% or more after being irradiated with an electron beam of $1 \times 10^{15}$ electrons/cm$^2$ at an energy amount of 1 MeV.

15. The glass according to any one of the above 1 to 14, having an average thermal expansion coefficient at 50°C to 350°C of $20 \times 10^{-7}$/°C to $100 \times 10^{-7}$/°C.

16. The glass according to any one of the above 1 to 15, being chemically strengthenable.

17. The glass according to any one of the above 1 to 16, being a cover glass for a solar cell.

18. The glass according to any one of the above 1 to 17, being a glass for cutting an electron beam.

19. The glass according to any one of the above 1 to 18, being a glass for cutting an ultraviolet ray.

EXAMPLES

Hereinafter, the present invention is described in detail with reference to Examples, but the present invention is not limited thereto.

(Preparation of Glass)

Generally used glass raw materials such as oxides, hydroxides, carbonates, or nitrates were appropriately selected such that glasses shown in Tables 1 to 17 have the glass compositions shown in the tables in terms mass% or mol% based on oxides, charged into a platinum crucible, and melted by heating to a high temperature of 1550°C to 1650°C or higher in an electric furnace, and thereafter, the glass melt was poured onto a carbon mold and kept at Tg+50°C for 30 minutes, and then cooled at a rate of 1.0°C/min to obtain a glass block. The obtained glass block was cut, ground, and polished to obtain a glass substrate having a length of 50 mm, a width of 50 mm, and a thickness of 0.1 mm, and a glass substrate having a length of 50 mm, a width of 50 mm, and a thickness of 0.5 mm.

(Preparation of Chemically Strengthened Glass)

Subsequently, the obtained glass substrate having a thickness of 0.5 mm was subjected to a chemical strengthening treatment using 100 mass% of potassium nitrate at 425°C for 6 hours to obtain a chemically strengthened glass substrate, and the chemically strengthened glass substrate was subjected to evaluation of chemical strengthening properties to measure the surface compressive stress (CS) and the compressive stress layer depth (DOL).

(Evaluation of Properties)

The properties of the obtained glass substrate and chemically strengthened glass substrate were evaluated by the following procedures.

[Transmittance]

The transmittance was measured using a spectrophotometer (trade name: U-4100) manufactured by Hitachi High-Tech Corporation. (Transmittance after Ultraviolet Ray Irradiation)

The UVA irradiation was performed by a method in which the glass substrate to be irradiated was left to stand horizontally on a table, and irradiated with light of a high-pressure mercury lamp (model number: QRU-2161-DYB manufactured by ORC MANUFACTURING CO., LTD.) for 10 minutes from a position 15 cm above the glass substrate. The transmittance was measured for each glass substrate after irradiation at an integrated light amount of 24.6 J/cm$^2$. Note that, at this time, an average illuminance at the installation location of the glass substrate was 41 mW/cm$^2$ at a wavelength of 365 nm (measured by an illuminometer UV-M08-25 manufactured by ORC MANUFACTURING CO., LTD.).

The UVC irradiation was performed by a method in which the glass substrate to be irradiated was left to stand horizontally on a table and irradiated with light of a low-pressure mercury lamp (desktop surface treatment apparatus (model number: SSP16-110, main wavelengths were 185 nm and 254 nm) manufactured by SEN LIGHTS Corporation) for 15 minutes from a position 50 cm above the glass substrate. The transmittance was measured for each glass substrate after irradiation at an integrated light amount of 27.9 J/cm$^2$. Note that, at this time, the average illuminance at the installation location of the glass substrate was 31 mW/cm$^2$ at a wavelength of 254 nm (measured by an illuminometer UV-M08-25 manufactured by ORC MANUFACTURING CO., LTD.).

(Transmittance after Electron Beam Irradiation)

The electron beam irradiation was performed by a method in which the glass substrate to be irradiated was left to stand horizontally on a table, and the glass substrate was irradiated with an electron beam of $1 \times 10^{15}$ electrons/cm$^2$ at an energy amount of 1 MeV using an electron beam irradiation apparatus (model number: EPS-3000 kV manufactured by NHV Corporation). The transmittance was measured for each glass substrate after the electron beam irradiation. The measurement was performed within one week.

[Average Thermal Expansion Coefficient]

The average thermal expansion coefficient was measured using a differential thermal expansion meter according to a method defined in JIS R3102 (1995). A measurement temperature range was 50°C to 350°C, and the unit was $\times 10^{-7}$/°C.

[Stress Profile (CS, DOL)]

The stress value of the chemically strengthened glass substrate obtained above was measured using an optical waveguide surface stress meter FSM-6000 manufactured by **Orihara** Industrial Co., Ltd.

[$T_2$ (temperature at which logarithm of viscosity $\eta$ (dPa·s) is 2)]

The $T_2$ was determined according to a method defined in ASTM C965-96 (2017), by measuring the viscosity using a high temperature rotary viscometer, and determining the temperature at which the viscosity was $10^2$ dPa·s. Note that, NBS 710 and NIST 717a were used as reference samples for device calibration.

[Devitrification Temperature]

The devitrification temperature was determined by placing the glass on a platinum dish, followed by charging into an electric furnace, holding at 1300°C for 1 hour, and then holding at a predetermined temperature for 17 hours, and the sample was removed from the electric furnace, and cooled. After the temperature was lowered to room temperature, the occurrence of devitrification was checked using a microscope. The temperature at which the glass was held for 17 hours was tested every 10°C, and the highest temperature at which devitrification was observed was determined as the devitrification temperature of the glass.

[Devitrification Viscosity]

As the devitrification viscosity, the viscosity was measured using the high temperature rotary viscometer described in the section of [$T_2$] while lowering the temperature from 1700°C to 1000°C (or until the viscosity started to increase rapidly due to devitrification) at a rate of 10°C/min , and the viscosity value at the above devitrification temperature was defined as the devitrification viscosity log $\eta$.

[Chemical Durability]

(Acid Resistance)

A glass was made into a rectangular glass plate having a rectangle shape that has one side of 40 mm ± 0.5 mm and having a thickness of 0.4 mm to 1.0 mm, the glass sample was immersed in an acid aqueous solution (a 90°C aqueous solution containing 0.1 mol/l HCl) for 20 hours, and an elution amount (mg/cm$^2$) of the glass component per unit surface area was evaluated. When a weight before immersion was represented as weight$_{Before}$, a weight after immersion was represented as weight$_{After}$, the length, the width, and the thickness of the glass sample were represented as length, width, and thickness, respectively, the elution amount of the glass component per unit surface area was determined according to the following formula.

$$\frac{weight_{Before} - weight_{After}}{length \times width \times 2 + (length + width) \times 2 \times thickness}$$

[Specific Gravity]

The specific gravity was measured by using the Archimedes method.

[Young's Modulus]

The Young's modulus was measured by using the ultrasonic pulse method (JIS R1602, 1995).
Tables 1 to 10 show the glass composition in terms of mass% based on oxides and the results of evaluating of the properties. In addition, Tables 11 to 17 show the glass composition in terms of mol% based on oxides for the composition shown in Tables 1 to 10.
In Tables 1 to 17, Examples A-1 to A-20, B-1 to B-8, B-11 to B-14, C-1 to C-7, C-12 to C-23, and D-1 to D-5 are Working Examples, and Examples A-21, A-22, B-9, B-10, B-15 to B-20, and C-8 to C-11 are Comparative Examples. In Tables 1 to 10, "-" indicates that evaluation is not performed.
In the case of considering the transmittance at 0.1 mm based on the transmittance at 0.5 mm, the amount of the element absorbing a light can be considered to be 1/5 according to the Lambert-Beer's law.

[Table 1]

| wt% | A-1 | A-2 | A-3 | A-4 | A-5 | A-6 | A-7 |
|---|---|---|---|---|---|---|---|
| SiO$_2$ | 64.3 | 58.8 | 59.9 | 59.9 | 59.8 | 59.7 | 59.8 |
| Al$_2$O$_3$ | 9.8 | 9.0 | 12.6 | 12.6 | 12.6 | 12.6 | 12.6 |
| B$_2$O$_3$ | 0.0 | 0.0 | 0.0 | 0.0 | 0.0 | 0.0 | 0.0 |
| MgO | 6.8 | 6.2 | 6.5 | 6.5 | 6.5 | 6.5 | 6.5 |
| CaO | 0.1 | 0.1 | 0.0 | 0.0 | 0.0 | 0.0 | 0.0 |
| SrO | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 |
| Li$_2$O | 0.0 | 0.0 | 0.0 | 0.0 | 0.0 | 0.0 | 0.0 |
| Na$_2$O | 12.4 | 11.3 | 12.0 | 12.0 | 12.0 | 11.9 | 12.0 |
| K$_2$O | 6.0 | 5.5 | 5.8 | 5.8 | 5.8 | 5.8 | 5.8 |
| ZrO$_2$ | 0.0 | 0.0 | 1.0 | 1.0 | 1.0 | 0.9 | 1.0 |
| TiO$_2$ | 0.0 | 0.0 | 0.05 | 0.05 | 0.05 | 0.05 | 0.05 |
| CeO$_2$ | 0.6 | 9.1 | 1.3 | 1.5 | 1.8 | 2.0 | 1.5 |
| Fe$_2$O$_3$ | 0.00 | 0.00 | 0.83 | 0.73 | 0.59 | 0.49 | 0.83 |
| ZnO | 0.0 | 0.0 | 0.0 | 0.0 | 0.0 | 0.0 | 0.0 |
| La$_2$O$_3$ | 0.0 | 0.0 | 0.0 | 0.0 | 0.0 | 0.0 | 0.0 |
| Sb$_2$O$_3$ | 0.0 | 0.0 | 0.0 | 0.0 | 0.0 | 0.0 | 0.0 |
| SO$_3$ | 0.0 | 0.0 | 0.0 | 0.0 | 0.0 | 0.0 | 0.0 |

(continued)

| wt% | | A-1 | A-2 | A-3 | A-4 | A-5 | A-6 | A-7 |
|---|---|---|---|---|---|---|---|---|
| Cl | | 0.0 | 0.0 | 0.0 | 0.0 | 0.0 | 0.0 | 0.0 |
| total | | 100.0 | 100.0 | 100.0 | 100.0 | 100.0 | 100.0 | 100.0 |
| $Na_2O+K_2O$ | | 18.4 | 16.9 | 17.8 | 17.8 | 17.8 | 17.7 | 17.8 |
| $R_2O$ | | 18.4 | 16.9 | 17.8 | 17.8 | 17.8 | 17.7 | 17.8 |
| $Na_2O+MgO$ | | 19.2 | 17.5 | 18.5 | 18.5 | 18.5 | 18.5 | 18.5 |
| $SiO_2+Al_2O_3$ | | 74.1 | 67.8 | 72.5 | 72.5 | 72.4 | 72.3 | 72.4 |
| $CeO_2+SiO_2+Al_2O_3$ | | 74.7 | 76.9 | 73.8 | 73.9 | 74.1 | 74.2 | 73.9 |
| $CeO_2+1/2Al_2O_3+Fe_2O_3$ | | 5.5 | 13.6 | 8.4 | 8.5 | 8.6 | 8.7 | 8.6 |
| $CeO_2+Al_2O_3+Fe_2O_3$ | | 10.39 | 18.05 | 14.72 | 14.80 | 14.93 | 15.01 | 14.88 |
| Wavelength @ 0.1 mm showing transmittance of 2% | nm | 290 | 338 | 302 | 314 | 316 | 318 | 316 |
| Visible light average transmittance (380 nm to 780 nm) @ 0.1 mm | % | 92 | 91 | 91 | 91 | 92 | 92 | 91 |
| Wavelength @ 0.1 mm showing transmittance of 2% after electron beam irradiation | nm | - | - | - | - | - | - | - |
| Visible light average transmittance (380 nm to 780 nm) @ 0.1 mm after electron beam irradiation | % | - | - | - | - | - | - | - |
| Wavelength @ 0.1 mm showing transmittance of 2% after UVC irradiation | nm | - | - | - | - | - | - | - |
| Visible light average transmittance (380 nm to 780 nm) @ 0.1 mm after ultraviolet ray irradiation | % | - | - | - | - | - | - | - |
| Amount of $CeO_2$ in case of converting 0.5 mm to 0.1 mm | wt% | - | - | - | - | - | - | - |
| Wavelength @ 0.5 mm showing transmittance of 2% | nm | - | - | - | - | - | - | - |
| Visible light average transmittance (380 nm to 780 nm) @ 0.5 mm | % | - | - | - | - | - | - | - |
| Wavelength @ 0.5 mm showing transmittance of 2% after electron beam irradiation | nm | - | - | - | - | - | - | - |
| Visible light average transmittance (380 nm to 780 nm) @ 0.5 mm after electron beam irradiation | % | - | - | - | - | - | - | - |
| Wavelength @ 0.5 mm showing transmittance of 2% after UVA irradiation | nm | - | - | - | - | - | - | - |

(continued)

| wt% | | A-1 | A-2 | A-3 | A-4 | A-5 | A-6 | A-7 |
|---|---|---|---|---|---|---|---|---|
| Visible light average transmittance (380 nm to 780 nm) @ 0.5 mm after UVA irradiation | % | - | - | - | - | - | - | - |
| Wavelength @ 0.5 mm showing transmittance of 2% after UVC irradiation | nm | - | - | - | - | - | - | - |
| Visible light average transmittance (380 nm to 780 nm) @ 0.5 mm after UVC irradiation | % | - | - | - | - | - | - | - |
| Average thermal expansion coefficient at 50°C to 350°C | $\times 10^{-7}$/°C | - | - | - | - | - | - | - |
| Devitrification viscosity (log $\eta$) | dPa·s | 3.9 | - | 3.6 | 3.6 | 3.5 | 3.4 | 3.6 |
| Melting temperature $T_2$ | °C | 1606 | 1671 | 1617 | 1618 | 1619 | 1620 | 1619 |
| Chemical strengthening property CS | MPa | 803 | 856 | 814 | 817 | 821 | 824 | 817 |
| Chemical strengthening property DOL | $\mu$m | 48 | 41 | 48 | 48 | 48 | 48 | 48 |
| Acid resistance | mg/cm$^2$ | - | - | - | - | - | - | - |
| Specific gravity | g/cm$^3$ | 2.49 | 2.64 | 2.51 | 2.52 | 2.52 | 2.52 | 2.52 |
| Young's modulus | GPa | 74 | 76 | 74 | 74 | 74 | 74 | 74 |

[Table 2]

| wt% | A-8 | A-9 | A-10 | A-11 | A-12 | A-13 | A-14 |
|---|---|---|---|---|---|---|---|
| $SiO_2$ | 59.6 | 61.0 | 60.9 | 60.8 | 60.8 | 60.4 | 58.9 |
| $Al_2O_3$ | 12.6 | 12.8 | 12.8 | 12.8 | 12.8 | 12.7 | 12.4 |
| $B_2O_3$ | 0.0 | 0.0 | 0.0 | 0.0 | 0.0 | 0.0 | 0.0 |
| MgO | 6.5 | 6.7 | 6.7 | 6.6 | 6.6 | 6.6 | 6.4 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 |
| $Na_2O$ | 11.9 | 12.2 | 12.2 | 12.2 | 12.2 | 12.1 | 11.8 |
| $K_2O$ | 5.8 | 5.9 | 5.9 | 5.9 | 5.9 | 5.9 | 5.7 |
| $ZrO_2$ | 0.9 | 1.0 | 1.0 | 1.0 | 1.0 | 1.0 | 0.9 |
| $TiO_2$ | 0.05 | 0.05 | 0.05 | 0.05 | 0.05 | 0.05 | 0.05 |
| $CeO_2$ | 1.8 | 0.4 | 0.5 | 0.6 | 0.7 | 1.3 | 3.8 |
| $Fe_2O_3$ | 0.83 | 0.01 | 0.01 | 0.01 | 0.01 | 0.01 | 0.01 |
| ZnO | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 |
| Cl | 0.0 | 0.0 | 0.0 | 0.0 | 0.0 | 0.0 | 0.0 |

(continued)

| wt% | | A-8 | A-9 | A-10 | A-11 | A-12 | A-13 | A-14 |
|---|---|---|---|---|---|---|---|---|
| total | | 100.0 | 100.0 | 100.0 | 100.0 | 100.0 | 100.0 | 100.0 |
| $Na_2O+K_2O$ | | 17.7 | 18.1 | 18.1 | 18.1 | 18.1 | 18.0 | 17.5 |
| $R_2O$ | | 17.7 | 18.1 | 18.1 | 18.1 | 18.1 | 18.0 | 17.5 |
| $Na_2O+MgO$ | | 18.4 | 18.8 | 18.8 | 18.8 | 18.8 | 18.7 | 18.2 |
| $SiO_2+Al_2O_3$ | | 72.2 | 73.8 | 73.7 | 73.7 | 73.6 | 73.1 | 71.2 |
| $CeO_2+SiO_2+Al_2O_3$ | | 73.9 | 74.2 | 74.2 | 74.2 | 74.3 | 74.4 | 75.1 |
| $CeO_2+1/2Al_2O_3+Fe_2O_3$ | | 8.9 | 6.8 | 6.9 | 7.0 | 7.1 | 7.7 | 10.0 |
| $CeO_2+Al_2O_3+Fe_2O_3$ | | 15.13 | 13.24 | 13.33 | 13.41 | 13.50 | 14.01 | 16.24 |
| Wavelength @ 0.1 mm showing transmittance of 2% | nm | 316 | 211 | 217 | 223 | 230 | 267 | 340 |
| Visible light average transmittance (380 nm to 780 nm) @ 0.1 mm | % | 91 | 92 | 92 | 92 | 92 | 91 | 90 |
| Wavelength @ 0.1 mm showing transmittance of 2% after electron beam irradiation | nm | - | - | - | - | - | - | - |
| Visible light average transmittance (380 nm to 780 nm) @ 0.1 mm after electron beam irradiation | % | - | - | - | - | - | - | - |
| Wavelength @ 0.1 mm showing transmittance of 2% after UVC irradiation | nm | | | | | | | |
| Visible light average transmittance (380 nm to 780 nm) @ 0.1 mm after ultraviolet ray irradiation | % | - | - | - | - | - | - | - |
| Amount of $CeO_2$ in case of converting 0.5 mm to 0.1 mm | | | | | | | | |
| Wavelength @ 0.5 mm showing transmittance of 2% | nm | - | - | - | - | - | - | - |
| Visible light average transmittance (380 nm to 780 nm) @ 0.5 mm | % | - | - | - | - | - | - | - |
| Wavelength @ 0.5 mm showing transmittance of 2% after electron beam irradiation | nm | - | - | - | - | - | - | - |
| Visible light average transmittance (380 nm to 780 nm) @ 0.5 mm after electron beam irradiation | % | - | - | - | - | - | - | - |
| Wavelength @ 0.5 mm showing transmittance of 2% after UVA irradiation | nm | - | - | - | - | - | - | - |
| Visible light average transmittance (380 nm to 780 nm) @ 0.5 mm after UVA irradiation | % | - | - | - | - | - | - | - |

(continued)

| wt% | | A-8 | A-9 | A-10 | A-11 | A-12 | A-13 | A-14 |
|---|---|---|---|---|---|---|---|---|
| Wavelength @ 0.5 mm showing transmittance of 2% after UVC irradiation | nm | - | - | - | - | - | - | - |
| Visible light average transmittance (380 nm to 780 nm) @ 0.5 mm after UVC irradiation | % | | | | | | | |
| Average thermal expansion coefficient at 50°C to 350°C | $\times 10^{-7}$/°C | - | - | - | - | - | - | - |
| Devitrification viscosity (log $\eta$) | dPa·s | 3.5 | 4.0 | 3.9 | 3.9 | 3.8 | 3.6 | 2.7 |
| Melting temperature $T_2$ | °C | 1621 | 1604 | 1605 | 1606 | 1606 | 1611 | 1631 |
| Chemical strengthening property CS | MPa | 821 | 800 | 802 | 803 | 805 | 814 | 854 |
| Chemical strengthening property DOL | $\mu$m | 48 | 48 | 48 | 48 | 48 | 48 | 48 |
| Acid resistance | mg/cm$^2$ | - | - | - | - | - | - | - |
| Specific gravity | g/cm$^3$ | 2.52 | 2.48 | 2.49 | 2.49 | 2.49 | 2.50 | 2.55 |
| Young's modulus | GPa | 74 | 74 | 74 | 74 | 74 | 74 | 75 |

[Table 3]

| wt% | A-15 | A-16 | A-17 | A-18 | A-19 | A-20 | A-21 | A-22 |
|---|---|---|---|---|---|---|---|---|
| $SiO_2$ | 58.6 | 58.1 | 58.0 | 57.7 | 59.7 | 59.1 | 61.2 | 61.0 |
| $Al_2O_3$ | 12.3 | 12.2 | 12.2 | 12.2 | 12.6 | 12.4 | 12.9 | 12.8 |
| $B_2O_3$ | 0.0 | 0.0 | 0.0 | 0.0 | 0.0 | 0.0 | 0.0 | 0.0 |
| MgO | 6.4 | 6.4 | 6.3 | 6.3 | 6.5 | 6.5 | 6.7 | 6.7 |
| CaO | 0.0 | 0.1 | 0.0 | 0.0 | 0.0 | 0.0 | 0.0 | 0.0 |
| SrO | 0.0 | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 | 0.0 |
| $Na_2O$ | 11.7 | 11.6 | 11.6 | 11.5 | 11.9 | 11.8 | 12.2 | 12.2 |
| $K_2O$ | 5.7 | 5.7 | 5.6 | 5.6 | 5.8 | 5.8 | 6.0 | 5.9 |
| $ZrO_2$ | 0.9 | 0.9 | 0.9 | 0.9 | 0.9 | 0.9 | 1.0 | 1.0 |
| $TiO_2$ | 0.05 | 0.05 | 0.05 | 0.05 | 0.05 | 0.05 | 0.00 | 0.05 |
| $CeO_2$ | 4.3 | 5.0 | 5.2 | 5.7 | 0.5 | 0.5 | 0.0 | 0.3 |
| $Fe_2O_3$ | 0.01 | 0.01 | 0.01 | 0.01 | 1.95 | 2.90 | 0.01 | 0.01 |
| ZnO | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 |
| Cl | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 |
| $Na_2O+K_2O$ | 17.4 | 17.3 | 17.2 | 17.2 | 17.7 | 17.6 | 18.2 | 18.1 |

(continued)

| wt% | | A-15 | A-16 | A-17 | A-18 | A-19 | A-20 | A-21 | A-22 |
|---|---|---|---|---|---|---|---|---|---|
| $R_2O$ | | 17.4 | 17.3 | 17.2 | 17.2 | 17.7 | 17.6 | 18.2 | 18.1 |
| $Na_2O+MgO$ | | 18.1 | 18.0 | 17.9 | 17.9 | 18.5 | 18.3 | 18.9 | 18.9 |
| $SiO_2+Al_2O_3$ | | 70.9 | 70.3 | 70.2 | 69.9 | 72.3 | 71.6 | 74.1 | 73.9 |
| $CeO_2+SiO_2+Al_2O_3$ | | 75.2 | 75.3 | 75.4 | 75.6 | 72.8 | 72.1 | 74.1 | 74.2 |
| $CeO_2+1/2Al_2O_3+Fe_2O_3$ | | 10.5 | 11.1 | 11.3 | 11.7 | 8.7 | 9.6 | 6.5 | 6.7 |
| $CeO_2+Al_2O_3+Fe_2O_3$ | | 16.64 | 17.25 | 17.43 | 17.82 | 15.01 | 15.83 | 12.90 | 13.15 |
| Wavelength @ 0.1 mm showing transmittance of 2% | nm | 340 | 340 | 340 | 340 | 318 | 324 | 200 | 205 |
| Visible light average transmittance (380 nm to 780 nm) @ 0.1 mm | % | 90 | 90 | 90 | 90 | 90 | 90 | 92 | 92 |
| Wavelength @ 0.1 mm showing transmittance of 2% after electron beam irradiation | nm | - | - | - | - | - | - | 230 | - |
| Visible light average transmittance (380 nm to 780 nm) @ 0.1 mm after electron beam irradiation | % | - | - | - | - | - | - | 84 | - |
| Wavelength @ 0.1 mm showing transmittance of 2% after UVC irradiation | nm | - | - | - | - | - | - | - | - |
| Visible light average transmittance (380 nm to 780 nm) @ 0.1 mm after ultraviolet ray irradiation | % | - | - | - | - | - | - | - | - |
| Amount of $CeO_2$ in case of converting 0.5 mm to 0.1 mm | | - | - | - | - | - | - | 0.0 | - |
| Wavelength @ 0.5 mm showing transmittance of 2% | nm | - | - | - | - | - | - | 268 | - |
| Visible light average transmittance (380 nm to 780 nm) @ 0.5 mm | % | - | - | - | - | - | - | 92 | - |
| Wavelength @ 0.5 mm showing transmittance of 2% after electron beam irradiation | nm | - | - | - | - | - | - | 316 | - |

(continued)

| wt% | | A-15 | A-16 | A-17 | A-18 | A-19 | A-20 | A-21 | A-22 |
|---|---|---|---|---|---|---|---|---|---|
| Visible light average transmittance (380 nm to 780 nm) @ 0.5 mm after electron beam irradiation | % | - | - | - | - | - | - | 34 | - |
| Wavelength @ 0.5 mm showing transmittance of 2% after UVA irradiation | nm | - | - | - | - | - | - | - | - |
| Visible light average transmittance (380 nm to 780 nm) @ 0.5 mm after UVA irradiation | % | - | - | - | - | - | - | - | - |
| Wavelength @ 0.5 mm showing transmittance of 2% after UVC irradiation | nm | - | - | - | - | - | - | - | - |
| Visible light average transmittance (380 nm to 780 nm) @ 0.5 mm after UVC irradiation | % | - | - | - | - | - | - | - | - |
| Average thermal expansion coefficient at 50°C to 350°C | $\times 10^{-7}/°C$ | - | - | - | - | - | - | 98 | - |
| Devitrification viscosity (log $\eta$) | dPa·s | 2.5 | 2.3 | 2.2 | 2.0 | 3.9 | 3.9 | 4.1 | 4.0 |
| Melting temperature $T_2$ | °C | 1634 | 1639 | 1641 | 1644 | 1620 | 1627 | 1601 | 1603 |
| Chemical strengthening property CS | MPa | 856 | 856 | 856 | 856 | 802 | 801 | 794 | 799 |
| Chemical strengthening property DOL | $\mu$m | 41 | 41 | 41 | 48 | 48 | 48 | 48 | 48 |
| Acid resistance | mg/cm$^2$ | - | - | - | - | - | - | 0.06 | - |
| Specific gravity | g/cm$^3$ | 2.55 | 2.57 | 2.57 | 2.58 | 2.52 | 2.54 | 2.48 | 2.48 |
| Young's modulus | GPa | 75 | 75 | 75 | 75 | 74 | 75 | 74 | 74 |

[Table 4]

| wt% | B-1 | B-2 | B-3 | B-4 | B-5 | B-6 | B-7 |
|---|---|---|---|---|---|---|---|
| $SiO_2$ | 59.7 | 59.5 | 59.6 | 59.3 | 59.1 | 59.0 | 59.5 |
| $Al_2O_3$ | 16.5 | 16.4 | 16.4 | 16.4 | 16.3 | 16.3 | 16.4 |
| $B_2O_3$ | 0.0 | 0.0 | 0.0 | 0.0 | 0.0 | 0.0 | 0.0 |
| MgO | 5.2 | 5.2 | 5.2 | 5.1 | 5.1 | 5.1 | 5.2 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |

(continued)

| wt% | | B-1 | B-2 | B-3 | B-4 | B-5 | B-6 | B-7 |
|---|---|---|---|---|---|---|---|---|
| BaO | | 0.0 | 0.0 | 0.0 | 0.0 | 0.0 | 0.0 | 0.0 |
| $Li_2O$ | | 0.0 | 0.0 | 0.0 | 0.0 | 0.0 | 0.0 | 0.0 |
| $Na_2O$ | | 15.3 | 15.3 | 15.3 | 15.2 | 15.2 | 15.1 | 15.3 |
| $K_2O$ | | 1.2 | 1.2 | 1.2 | 1.2 | 1.2 | 1.2 | 1.2 |
| $ZrO_2$ | | 0.3 | 0.3 | 0.3 | 0.3 | 0.3 | 0.3 | 0.3 |
| $TiO_2$ | | 0.59 | 0.29 | 0.05 | 0.05 | 0.05 | 0.05 | 0.05 |
| $CeO_2$ | | 1.3 | 1.9 | 2.0 | 2.0 | 2.0 | 2.0 | 1.3 |
| $Fe_2O_3$ | | 0.05 | 0.05 | 0.01 | 0.49 | 0.85 | 0.99 | 0.85 |
| ZnO | | 0.0 | 0.0 | 0.0 | 0.0 | 0.0 | 0.0 | 0.0 |
| $La_2O_3$ | | 0.0 | 0.0 | 0.0 | 0.0 | 0.0 | 0.0 | 0.0 |
| $Sb_2O_3$ | | 0.0 | 0.0 | 0.0 | 0.0 | 0.0 | 0.0 | 0.0 |
| $SO_3$ | | 0.0 | 0.0 | 0.0 | 0.0 | 0.0 | 0.0 | 0.0 |
| Cl | | 0.0 | 0.0 | 0.0 | 0.0 | 0.0 | 0.0 | 0.0 |
| total | | 100.0 | 100.0 | 100.0 | 100.0 | 100.0 | 100.0 | 100.0 |
| $Na_2O+K_2O$ | | 16.5 | 16.4 | 16.5 | 16.4 | 16.3 | 16.3 | 16.4 |
| $R_2O$ | | 16.5 | 16.4 | 16.5 | 16.4 | 16.3 | 16.3 | 16.4 |
| $Na_2O+MgO$ | | 20.5 | 20.4 | 20.5 | 20.4 | 20.3 | 20.3 | 20.4 |
| $SiO_2+Al_2O_3$ | | 76.2 | 75.9 | 76.0 | 75.7 | 75.4 | 75.3 | 75.9 |
| $CeO_2+SiO_2+Al_2O_3$ | | 77.4 | 77.8 | 78.0 | 77.7 | 77.4 | 77.3 | 77.2 |
| $CeO_2+1/2Al_2O_3+Fe_2O_3$ | | 9.5 | 10.2 | 10.2 | 10.7 | 11.0 | 11.1 | 10.4 |
| $CeO_2+Al_2O_3+Fe_2O_3$ | | 17.78 | 18.35 | 18.45 | 18.85 | 19.15 | 19.26 | 18.56 |
| Wavelength @ 0.1 mm showing transmittance of 2% | nm | 266 | 277 | 315 | 319 | 320 | 322 | 309 |
| Visible light average transmittance (380 nm to 780 nm) @ 0.1 mm | % | 92 | 91 | 92 | 92 | 91 | 91 | 91 |
| Wavelength @ 0.1 mm showing transmittance of 2% after electron beam irradiation | nm | 271 | 290 | - | - | - | - | - |
| Visible light average transmittance (380 nm to 780 nm) @ 0.1 mm after electron beam irradiation | % | 91 | 92 | - | - | - | - | - |
| Wavelength @ 0.1 mm showing transmittance of 2% after UVC irradiation | nm | - | - | 319 | 319 | 320 | 322 | 311 |
| Visible light average transmittance (380 nm to 780 nm) @ 0.1 mm after ultraviolet ray irradiation | % | - | - | 92 | 91 | 91 | 90 | 91 |
| Amount of $CeO_2$ in case of converting 0.5 mm to 0.1 mm | | 6.4 | 9.5 | - | - | - | - | - |
| Wavelength @ 0.5 mm showing transmittance of 2% | nm | 334 | 338 | - | - | - | - | - |

(continued)

| wt% | | B-1 | B-2 | B-3 | B-4 | B-5 | B-6 | B-7 |
|---|---|---|---|---|---|---|---|---|
| Visible light average transmittance (380 nm to 780 nm) @ 0.5 mm | % | 91 | 91 | - | - | - | - | - |
| Wavelength @ 0.5 mm showing transmittance of 2% after electron beam irradiation | nm | 340 | 342 | - | - | - | - | - |
| Visible light average transmittance (380 nm to 780 nm) @ 0.5 mm after electron beam irradiation | % | 88 | 90 | - | - | - | - | - |
| Wavelength @ 0.5 mm showing transmittance of 2% after UVA irradiation | nm | - | - | - | - | - | - | - |
| Visible light average transmittance (380 nm to 780 nm) @ 0.5 mm after UVA irradiation | % | - | - | - | - | - | - | - |
| Wavelength @ 0.5 mm showing transmittance of 2% after UVC irradiation | nm | - | - | - | - | - | - | - |
| Visible light average transmittance (380 nm to 780 nm) @ 0.5 mm after UVC irradiation | % | - | - | - | - | - | - | - |
| Average thermal expansion coefficient at 50°C to 350°C | $\times 10^{-7}/°C$ | - | - | - | - | - | - | - |
| Devitrification viscosity (log $\eta$) | dPa·s | 4.1 | 3.9 | 3.9 | 3.9 | 3.9 | 3.9 | 4.1 |
| Melting temperature $T_2$ | °C | 1652 | 1657 | 1657 | 1661 | 1664 | 1665 | 1658 |
| Chemical strengthening property CS | MPa | 1047 | 1060 | 1062 | 1062 | 1062 | 1062 | 1048 |
| Chemical strengthening property DOL | $\mu$m | 39 | 39 | 39 | 39 | 39 | 39 | 39 |
| Acid resistance | $mg/cm^2$ | - | - | - | - | - | - | - |
| Specific gravity | $g/cm^3$ | 2.48 | 2.50 | 2.50 | 2.51 | 2.51 | 2.51 | 2.50 |
| Young's modulus | GPa | 74 | 74 | 74 | 74 | 74 | 74 | 74 |

[Table 5]

| wt% | B-8 | B-9 | B-10 | B-11 | B-12 | B-13 |
|---|---|---|---|---|---|---|
| $SiO_2$ | 60.0 | 60.5 | 60.2 | 57.8 | 54.7 | 59.8 |
| $Al_2O_3$ | 16.5 | 16.7 | 16.6 | 15.9 | 15.1 | 16.5 |
| $B_2O_3$ | 0.0 | 0.0 | 0.0 | 0.0 | 0.0 | 0.0 |
| MgO | 5.2 | 5.2 | 5.2 | 5.0 | 4.7 | 5.2 |
| CaO | 0.0 | 0.0 | 0.0 | 0.0 | 0.0 | 0.0 |
| SrO | 0.0 | 0.0 | 0.0 | 0.0 | 0.0 | 0.0 |
| BaO | 0.0 | 0.0 | 0.0 | 0.0 | 0.0 | 0.0 |
| $Li_2O$ | 0.0 | 0.0 | 0.0 | 0.0 | 0.0 | 0.0 |
| $Na_2O$ | 15.4 | 15.5 | 15.5 | 14.8 | 14.0 | 15.3 |

(continued)

| wt% | | B-8 | B-9 | B-10 | B-11 | B-12 | B-13 |
|---|---|---|---|---|---|---|---|
| $K_2O$ | | 1.2 | 1.2 | 1.2 | 1.1 | 1.1 | 1.2 |
| $ZrO_2$ | | 0.3 | 0.3 | 0.3 | 0.3 | 0.3 | 0.3 |
| $TiO_2$ | | 0.05 | 0.05 | 0.05 | 0.05 | 0.05 | 0.67 |
| $CeO_2$ | | 0.5 | 0.0 | 0.0 | 5.0 | 10.0 | 0.4 |
| $Fe_2O_3$ | | 0.85 | 0.50 | 1.00 | 0.01 | 0.01 | 0.67 |
| $ZnO$ | | 0.0 | 0.0 | 0.0 | 0.0 | 0.0 | 0.0 |
| $La_2O_3$ | | 0.0 | 0.0 | 0.0 | 0.0 | 0.0 | 0.0 |
| $Sb_2O_3$ | | 0.0 | 0.0 | 0.0 | 0.0 | 0.0 | 0.0 |
| $SO_3$ | | 0.0 | 0.0 | 0.0 | 0.0 | 0.0 | 0.0 |
| $Cl$ | | 0.0 | 0.0 | 0.0 | 0.0 | 0.0 | 0.0 |
| total | | 100.0 | 100.0 | 100.0 | 100.0 | 100.0 | 100.0 |
| $Na_2O+K_2O$ | | 16.6 | 16.7 | 16.6 | 16.0 | 15.1 | 16.5 |
| $R_2O$ | | 16.6 | 16.7 | 16.6 | 16.0 | 15.1 | 16.5 |
| $Na_2O+MgO$ | | 20.6 | 20.8 | 20.7 | 19.8 | 18.8 | 20.5 |
| $SiO_2+Al_2O_3$ | | 76.5 | 77.2 | 76.8 | 73.7 | 69.8 | 76.3 |
| $CeO_2+SiO_2+Al_2O_3$ | | 77.0 | 77.2 | 76.8 | 78.7 | 79.8 | 76.7 |
| $CeO_2+1/2Al_2O_3+Fe_2O_3$ | | 9.6 | 8.8 | 9.3 | 13.0 | 17.6 | 9.3 |
| $CeO_2+Al_2O_3+Fe_2O_3$ | | 17.90 | 17.19 | 17.61 | 20.94 | 25.10 | 17.58 |
| Wavelength @ 0.1 mm showing transmittance of 2% | nm | 298 | - | - | 340 | 340 | 300 |
| Visible light average transmittance (380 nm to 780 nm) @ 0.1 mm | % | 91 | - | - | 90 | 10 | 91 |
| Wavelength @ 0.1 mm showing transmittance of 2% after electron beam irradiation | nm | - | - | - | - | - | 305 |
| Visible light average transmittance (380 nm to 780 nm) @ 0.1 mm after electron beam irradiation | % | - | - | - | - | - | 91 |
| Wavelength @ 0.1 mm showing transmittance of 2% after UVC irradiation | nm | 300 | - | - | - | - | - |
| Visible light average transmittance (380 nm to 780 nm) @ 0.1 mm after ultraviolet ray irradiation | % | 91 | | | | | |
| Amount of $CeO_2$ in case of converting 0.5 mm to 0.1 mm | | | | | | | 2.1 |
| Wavelength @ 0.5 mm showing transmittance of 2% | nm | - | - | - | - | - | 328 |
| Visible light average transmittance (380 nm to 780 nm) @ 0.5 mm | % | - | - | - | - | - | 86 |
| Wavelength @ 0.5 mm showing transmittance of 2% after electron beam irradiation | nm | - | - | - | - | - | 334 |

(continued)

| wt% | | B-8 | B-9 | B-10 | B-11 | B-12 | B-13 |
|---|---|---|---|---|---|---|---|
| Visible light average transmittance (380 nm to 780 nm) @ 0.5 mm after electron beam irradiation | % | | | | | | 84 |
| Wavelength @ 0.5 mm showing transmittance of 2% after UVA irradiation | nm | - | - | - | - | - | - |
| Visible light average transmittance (380 nm to 780 nm) @ 0.5 mm after UVA irradiation | % | - | - | - | - | - | - |
| Wavelength @ 0.5 mm showing transmittance of 2% after UVC irradiation | nm | - | - | - | - | - | - |
| Visible light average transmittance (380 nm to 780 nm) @ 0.5 mm after UVC irradiation | % | - | - | - | - | - | - |
| Average thermal expansion coefficient at 50°C to 350°C | $\times 10^{-7}/°C$ | - | - | - | - | - | - |
| Devitrification viscosity (log $\eta$) | dPa·s | 4.4 | 4.6 | 4.6 | 2.8 | - | 4.4 |
| Melting temperature $T_2$ | °C | 1652 | 1646 | 1650 | 1680 | 1719 | 1650 |
| Chemical strengthening property CS | MPa | 1032 | 1022 | 1022 | 1102 | 1102 | 1030 |
| Chemical strengthening property DOL | $\mu$m | 39 | 39 | 39 | 35 | 35 | 39 |
| Acid resistance | mg/cm$^2$ | - | - | - | - | - | - |
| Specific gravity | g/cm$^3$ | 2.48 | 2.47 | 2.48 | 2.55 | 2.64 | 2.48 |
| Young's modulus | GPa | 74 | 74 | 74 | 75 | 77 | 74 |

[Table 6]

| wt% | B-14 | B-15 | B-16 | B-17 | B-18 | B-19 | B-20 |
|---|---|---|---|---|---|---|---|
| $SiO_2$ | 60.0 | 60.8 | 60.8 | 60.7 | 60.6 | 60.5 | 60.4 |
| $Al_2O_3$ | 16.5 | 16.8 | 16.8 | 16.8 | 16.7 | 16.7 | 16.7 |
| $B_2O_3$ | 0.0 | 0.0 | 0.0 | 0.0 | 0.0 | 0.0 | 0.0 |
| MgO | 5.2 | 5.3 | 5.3 | 5.3 | 5.3 | 5.2 | 5.2 |
| CaO | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 |
| $Na_2O$ | 15.4 | 15.6 | 15.6 | 15.6 | 15.6 | 15.5 | 15.5 |
| $K_2O$ | 1.2 | 1.2 | 1.2 | 1.2 | 1.2 | 1.2 | 1.2 |
| $ZrO_2$ | 0.3 | 0.3 | 0.3 | 0.3 | 0.3 | 0.3 | 0.3 |
| $TiO_2$ | 0.05 | 0.0 | 0.05 | 0.05 | 0.05 | 0.50 | 0.50 |
| $CeO_2$ | 1.3 | 0.0 | 0.0 | 0.1 | 0.3 | 0.1 | 0.3 |
| $Fe_2O_3$ | 0.01 | 0.01 | 0.01 | 0.01 | 0.01 | 0.01 | 0.01 |
| ZnO | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 |

(continued)

| wt% | | B-14 | B-15 | B-16 | B-17 | B-18 | B-19 | B-20 |
|---|---|---|---|---|---|---|---|---|
| $SO_3$ | | 0.0 | 0.0 | 0.0 | 0.0 | 0.0 | 0.0 | 0.0 |
| Cl | | 0.0 | 0.0 | 0.0 | 0.0 | 0.0 | 0.0 | 0.0 |
| total | | 100.0 | 100.0 | 100.0 | 100.0 | 100.0 | 100.0 | 100.0 |
| $Na_2O+K_2O$ | | 16.6 | 16.8 | 16.8 | 16.8 | 16.8 | 16.7 | 16.7 |
| $R_2O$ | | 16.6 | 16.8 | 16.8 | 16.8 | 16.8 | 16.7 | 16.7 |
| $Na_2O+MgO$ | | 20.6 | 20.9 | 20.9 | 20.8 | 20.8 | 20.8 | 20.7 |
| $SiO_2+Al_2O_3$ | | 76.5 | 77.6 | 77.6 | 77.5 | 77.4 | 77.1 | 77.0 |
| $CeO_2+SiO_2+Al_2O_3$ | | 77.9 | 77.6 | 77.6 | 77.6 | 77.6 | 77.3 | 77.3 |
| $CeO_2+1/2Al_2O_3+Fe_2O_3$ | | 9.6 | 8.4 | 8.4 | 8.5 | 8.6 | 8.5 | 8.6 |
| $CeO_2+Al_2O_3+Fe_2O_3$ | | 17.89 | 16.79 | 16.80 | 16.89 | 17.01 | 16.82 | 16.93 |
| Wavelength @ 0.1 mm showing transmittance of 2% | nm | 267 | 241 | 241 | 241 | 241 | 248 | 249 |
| Visible light average transmittance (380 nm to 780 nm) @ 0.1 mm | % | 92 | 92 | 92 | 92 | 92 | 92 | 92 |
| Wavelength @ 0.1 mm showing transmittance of 2% after electron beam irradiation | nm | - | 230 | 241 | 241 | - | - | - |
| Visible light average transmittance (380 nm to 780 nm) @ 0.1 mm after electron beam irradiation | % | - | 84 | 70 | 70 | - | - | - |
| Wavelength @ 0.1 mm showing transmittance of 2% after UVC irradiation | nm | - | - | - | - | - | - | - |
| Visible light average transmittance (380 nm to 780 nm) @ 0.1 mm after ultraviolet ray irradiation | % | - | - | - | - | - | - | - |
| Amount of $CeO_2$ in case of converting 0.5 mm to 0.1 mm | | 6.7 | 0.0 | 0.0 | 0.7 | 1.4 | 0.7 | 1.4 |
| Wavelength @ 0.5 mm showing transmittance of 2% | nm | 333.0 | - | 245.0 | 257.0 | 272.0 | 273.0 | 281.0 |
| Visible light average transmittance (380 nm to 780 nm) @ 0.5 mm | % | 91.7 | - | 92.2 | 92.2 | 92.1 | 91.9 | 92.0 |
| Wavelength @ 0.5 mm showing transmittance of 2% after electron beam irradiation | nm | 338.0 | - | 241.0 | 268.0 | 314.0 | 288.0 | 317.0 |
| Visible light average transmittance (380 nm to 780 nm) @ 0.5 mm after electron beam irradiation | % | 90.9 | - | 69.7 | 76.6 | 81.9 | 75.4 | 80.6 |
| Wavelength @ 0.5 mm showing transmittance of 2% after UVA irradiation | nm | 336.0 | - | 249.0 | 280.0 | 309.0 | 287.0 | 306.0 |

(continued)

| wt% | | B-14 | B-15 | B-16 | B-17 | B-18 | B-19 | B-20 |
|---|---|---|---|---|---|---|---|---|
| Visible light average transmittance (380 nm to 780 nm) @ 0.5 mm after UVA irradiation | % | 91.3 | - | 91.7 | 91.5 | 91.5 | 91.3 | 91.0 |
| Wavelength @ 0.5 mm showing transmittance of 2% after UVC irradiation | nm | 336.0 | - | 249.0 | 277.0 | 310.0 | 288.0 | 311.0 |
| Visible light average transmittance (380 nm to 780 nm) @ 0.5 mm after UVC irradiation | % | 91.1 | - | 89.7 | 90.5 | 90.9 | 90.4 | 91.0 |
| Average thermal expansion coefficient at 50°C to 350°C | $\times 10^{-7}$/°C | - | 89.0 | - | - | - | - | - |
| Devitrification viscosity (log $\eta$) | dPa·s | 4.1 | 4.6 | 4.6 | 4.6 | 4.5 | 4.6 | 4.5 |
| Melting temperature $T_2$ | °C | 1652 | 1642 | 1642 | 1643 | 1644 | 1643 | 1644 |
| Chemical strengthening property CS | MPa | 1049 | 1022 | 1023 | 1025 | 1027 | 1025 | 1027 |
| Chemical strengthening property DOL | $\mu$m | 39 | 39 | 39 | 39 | 39 | 39 | 39 |
| Acid resistance | mg/cm$^2$ | - | 0.03 | - | - | - | - | - |
| Specific gravity | g/cm$^3$ | 2.48 | 2.46 | 2.46 | 2.46 | 2.47 | 2.46 | 2.47 |
| Young's modulus | GPa | 74 | 73 | 73 | 73 | 74 | 73 | 74 |

[Table 7]

| wt% | C-1 | C-2 | C-3 | C-4 | C-5 | C-6 | C-7 |
|---|---|---|---|---|---|---|---|
| $SiO_2$ | 66.9 | 67.1 | 65.0 | 67.3 | 67.4 | 67.7 | 67.7 |
| $Al_2O_3$ | 4.8 | 4.9 | 4.7 | 4.9 | 4.9 | 4.9 | 4.9 |
| $B_2O_3$ | 0.0 | 0.0 | 0.0 | 0.0 | 0.0 | 0.0 | 0.0 |
| MgO | 4.0 | 4.0 | 3.9 | 4.0 | 4.1 | 4.1 | 4.1 |
| CaO | 7.0 | 7.1 | 6.9 | 7.1 | 7.1 | 7.1 | 7.1 |
| SrO | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 |
| $Na_2O$ | 14.3 | 14.3 | 13.9 | 14.4 | 14.4 | 14.5 | 14.5 |
| $K_2O$ | 0.2 | 0.2 | 0.4 | 0.2 | 0.2 | 0.2 | 0.2 |
| $ZrO_2$ | 0.0 | 0.0 | 0.0 | 0.0 | 0.0 | 0.0 | 0.0 |
| $TiO_2$ | 0.00 | 0.31 | 0.05 | 0.62 | 0.71 | 0.00 | 0.05 |
| $CeO_2$ | 2.7 | 2.0 | 5.0 | 1.3 | 0.4 | 1.4 | 1.4 |
| $Fe_2O_3$ | 0.01 | 0.05 | 0.09 | 0.05 | 0.71 | 0.09 | 0.09 |
| ZnO | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 |
| Cl | 0.0 | 0.0 | 0.0 | 0.0 | 0.0 | 0.0 | 0.0 |

(continued)

| wt% | | C-1 | C-2 | C-3 | C-4 | C-5 | C-6 | C-7 |
|---|---|---|---|---|---|---|---|---|
| total | | 100.0 | 100.0 | 100.0 | 100.0 | 100.0 | 100.0 | 100.0 |
| $Na_2O+K_2O$ | | 14.5 | 14.6 | 14.2 | 14.6 | 14.7 | 14.7 | 14.7 |
| $R_2O$ | | 14.5 | 14.6 | 14.2 | 14.6 | 14.7 | 14.7 | 14.7 |
| $Na_2O+MgO$ | | 18.3 | 18.4 | 17.8 | 18.4 | 18.5 | 18.5 | 18.5 |
| $SiO_2+Al_2O_3$ | | 71.7 | 72.0 | 69.8 | 72.2 | 72.3 | 72.6 | 72.6 |
| $CeO_2+SiO_2+Al_2O_3$ | | 74.4 | 74.0 | 74.8 | 73.6 | 72.8 | 74.0 | 74.0 |
| $CeO_2+1/2Al_2O_3+Fe_2O_3$ | | 5.1 | 4.5 | 7.5 | 3.8 | 3.6 | 4.0 | 4.0 |
| $CeO_2+Al_2O_3+Fe_2O_3$ | | 7.56 | 6.91 | 9.83 | 6.27 | 6.04 | 6.40 | 6.40 |
| Wavelength @ 0.1 mm showing transmittance of 2% | nm | 319 | 277 | 340 | 266 | 300 | 285 | 285 |
| Visible light average transmittance (380 nm to 780 nm) @ 0.1 mm | % | 91 | 91 | 90 | 92 | 91 | 92 | 92 |
| Wavelength @ 0.1 mm showing transmittance of 2% after electron beam irradiation | nm | 321 | 290 | - | 271 | 305 | - | - |
| Visible light average transmittance (380 nm to 780 nm) @ 0.1 mm after electron beam irradiation | % | 92 | 92 | - | 91 | 91 | - | - |
| Wavelength @ 0.1 mm showing transmittance of 2% after UVC irradiation | nm | - | - | - | - | - | - | - |
| Visible light average transmittance (380 nm to 780 nm) @ 0.1 mm after ultraviolet ray irradiation | % | - | - | - | - | - | - | - |
| Amount of $CeO_2$ in case of converting 0.5 mm to 0.1 mm | | 13.6 | 10.0 | - | 6.7 | 2.2 | 7.1 | 7.1 |
| Wavelength @ 0.5 mm showing transmittance of 2% | nm | 337 | 339 | - | 336 | 330 | 336.0 | 336.0 |
| Visible light average transmittance (380 nm to 780 nm) @ 0.5 mm | % | 75 | 91 | - | 91 | 89 | 91.5 | 91.5 |
| Wavelength @ 0.5 mm showing transmittance of 2% after electron beam irradiation | nm | 336 | 343 | - | 340 | 333 | 339.0 | 340.0 |
| Visible light average transmittance (380 nm to 780 nm) @ 0.5 mm after electron beam irradiation | % | 76 | 91 | - | 90 | 86 | 91.1 | 90.6 |
| Wavelength @ 0.5 mm showing transmittance of 2% after UVA irradiation | nm | - | - | - | - | - | 338.0 | 338.0 |
| Visible light average transmittance (380 nm to 780 nm) @ 0.5 mm after UVA irradiation | % | - | - | - | - | - | 91.0 | 91.1 |

(continued)

| wt% | | C-1 | C-2 | C-3 | C-4 | C-5 | C-6 | C-7 |
|---|---|---|---|---|---|---|---|---|
| Wavelength @ 0.5 mm showing transmittance of 2% after UVC irradiation | nm | - | - | - | - | - | 338.0 | 338.0 |
| Visible light average transmittance (380 nm to 780 nm) @ 0.5 mm after UVC irradiation | % | - | - | - | - | - | 91.1 | 91.3 |
| Average thermal expansion coefficient at 50°C to 350°C | $\times 10^{-7}$/°C | - | - | - | - | - | - | - |
| Devitrification viscosity (log $\eta$) | dPa·s | 4.4 | 4.7 | 3.6 | 4.9 | 5.2 | 4.9 | 4.9 |
| Melting temperature $T_2$ | °C | 1462 | 1466 | 1449 | 1469 | 1471 | 1469 | 1469 |
| Chemical strengthening property CS | MPa | 797 | 772 | 841 | 749 | 718 | 752 | 752 |
| Chemical strengthening property DOL | $\mu$m | 15 | 15 | 12 | 15 | 15 | 15 | 15 |
| Acid resistance | mg/cm$^2$ | - | - | - | - | - | - | - |
| Specific gravity | g/cm$^3$ | 2.55 | 2.54 | 2.59 | 2.53 | 2.52 | 2.53 | 2.53 |
| Young's modulus | GPa | 76 | 75 | 76 | 75 | 75 | 75 | 75 |

[Table 8]

| wt% | C-8 | C-9 | C-10 | C-11 | C-12 | C-13 |
|---|---|---|---|---|---|---|
| $SiO_2$ | 68.7 | 67.0 | 68.6 | 68.5 | 67.0 | 67.9 |
| $Al_2O_3$ | 5.0 | 4.8 | 5.0 | 5.0 | 4.8 | 4.9 |
| $B_2O_3$ | 0.0 | 0.0 | 0.0 | 0.0 | 0.0 | 0.0 |
| MgO | 4.1 | 4.0 | 4.1 | 4.1 | 4.0 | 4.1 |
| CaO | 7.2 | 7.0 | 7.2 | 7.2 | 7.0 | 7.1 |
| SrO | 0.0 | 0.0 | 0.0 | 0.0 | 0.0 | 0.0 |
| BaO | 0.0 | 0.0 | 0.0 | 0.0 | 0.0 | 0.0 |
| $Li_2O$ | 0.0 | 0.0 | 0.0 | 0.0 | 0.0 | 0.0 |
| $Na_2O$ | 14.7 | 14.3 | 14.7 | 14.7 | 14.3 | 14.5 |
| $K_2O$ | 0.2 | 0.2 | 0.2 | 0.2 | 0.2 | 0.2 |
| $ZrO_2$ | 0.0 | 0.0 | 0.0 | 0.0 | 0.0 | 0.0 |
| $TiO_2$ | 0.0 | 0.0 | 0.05 | 0.05 | 0.00 | 0.00 |
| $CeO_2$ | 0.0 | 0.0 | 0.0 | 0.1 | 1.9 | 1.0 |
| $Fe_2O_3$ | 0.08 | 2.53 | 0.09 | 0.09 | 0.59 | 0.22 |
| ZnO | 0.0 | 0.0 | 0.0 | 0.0 | 0.0 | 0.0 |
| $La_2O_3$ | 0.0 | 0.0 | 0.0 | 0.0 | 0.0 | 0.0 |
| $Sb_2O_3$ | 0.0 | 0.0 | 0.0 | 0.0 | 0.0 | 0.0 |
| $SO_3$ | 0.0 | 0.0 | 0.0 | 0.0 | 0.0 | 0.0 |
| Cl | 0.0 | 0.0 | 0.0 | 0.0 | 0.0 | 0.0 |
| total | 100.0 | 100.0 | 100.0 | 100.0 | 100.0 | 100.0 |
| $Na_2O+K_2O$ | 14.9 | 14.6 | 14.9 | 14.9 | 14.5 | 14.7 |

(continued)

| wt% | | C-8 | C-9 | C-10 | C-11 | C-12 | C-13 |
|---|---|---|---|---|---|---|---|
| $R_2O$ | | 14.9 | 14.6 | 14.9 | 14.9 | 14.5 | 14.7 |
| $Na_2O+MgO$ | | 18.8 | 18.3 | 18.8 | 18.8 | 18.3 | 18.6 |
| $SiO_2+Al_2O_3$ | | 73.6 | 71.8 | 73.6 | 73.5 | 71.8 | 72.8 |
| $CeO_2+SiO_2+Al_2O_3$ | | 73.6 | 71.8 | 73.6 | 73.6 | 73.7 | 73.8 |
| $CeO_2+1/2Al_2O_3+Fe_2O_3$ | | 2.6 | 5.0 | 2.6 | 2.7 | 4.9 | 3.65 |
| $CeO_2+Al_2O_3+Fe_2O_3$ | | 5.05 | 7.38 | 5.08 | 5.19 | 7.3 | 6.1 |
| Wavelength @ 0.1 mm showing transmittance of 2% | nm | 243 | - | 250 | 243 | 292 | 271 |
| Visible light average transmittance (380 nm to 780 nm) @ 0.1 mm | % | 92 | 88 | 92 | 92 | 92 | 92 |
| Wavelength @ 0.1 mm showing transmittance of 2% after electron beam irradiation | nm | 234 | - | - | - | - | - |
| Visible light average transmittance (380 nm to 780 nm) @ 0.1 mm after electron beam irradiation | % | 82 | - | - | - | - | - |
| Wavelength @ 0.1 mm showing transmittance of 2% after UVC irradiation | nm | - | - | - | - | - | - |
| Visible light average transmittance (380 nm to 780 nm) @ 0.1 mm after ultraviolet ray irradiation | % | - | - | - | - | - | - |
| Amount of $CeO_2$ in case of converting 0.5 mm to 0.1 mm | | - | 0.0 | 0.1 | 0.7 | - | - |
| Wavelength @ 0.5 mm showing transmittance of 2% | nm | - | 343 | 283 | 287.0 | - | - |
| Visible light average transmittance (380 nm to 780 nm) @ 0.5 mm | % | - | 91 | 91.5 | 91.5 | - | - |
| Wavelength @ 0.5 mm showing transmittance of 2% after electron beam irradiation | nm | - | 345 | 286.0 | 302.0 | - | - |
| Visible light average transmittance (380 nm to 780 nm) @ 0.5 mm after electron beam irradiation | % | - | 91 | 72.0 | 79.3 | - | - |
| Wavelength @ 0.5 mm showing transmittance of 2% after UVA irradiation | nm | - | - | 289.0 | 306.0 | - | - |
| Visible light average transmittance (380 nm to 780 nm) @ 0.5 mm after UVA irradiation | % | - | - | 91.3 | 91.0 | - | - |
| Wavelength @ 0.5 mm showing transmittance of 2% after UVC irradiation | nm | - | - | 290.0 | 306.0 | - | - |
| Visible light average transmittance (380 nm to 780 nm) @ 0.5 mm after UVC irradiation | % | - | - | 90.4 | 90.9 | - | - |
| Average thermal expansion coefficient at 50°C to 350°C | $\times 10^{-7}/°C$ | 92 | - | - | - | - | - |
| Devitrification viscosity (log $\eta$) | dPa·s | 5.4 | 5.4 | 5.4 | 5.3 | 4.7 | 5.0 |

(continued)

| wt% | | C-8 | C-9 | C-10 | C-11 | C-12 | C-13 |
|---|---|---|---|---|---|---|---|
| Melting temperature $T_2$ | °C | 1477 | 1463 | 1476 | 1476 | 1463 | 1470 |
| Chemical strengthening property CS | MPa | 703 | 703 | 704 | 708 | 770 | 737 |
| Chemical strengthening property DOL | $\mu$m | 15 | 15 | 15 | 15 | 15 | 15 |
| Acid resistance | mg/cm$^2$ | 0.002 | - | - | - | - | - |
| Specific gravity | g/cm$^3$ | 2.50 | 2.55 | 2.50 | 2.50 | 2.55 | 2.52 |
| Young's modulus | GPa | 75 | 75 | 75 | 75 | 75 | 75 |

[Table 9]

| wt% | | C-14 | C-15 | C-16 | D-1 | D-2 | D-3 | D-4 | D-5 |
|---|---|---|---|---|---|---|---|---|---|
| $SiO_2$ | | 67.8 | 67.7 | 67.6 | 68.0 | 67.0 | 66.0 | 62.5 | 61.2 |
| $Al_2O_3$ | | 4.9 | 4.9 | 4.9 | 6.0 | 7.0 | 8.0 | 4.2 | 4.1 |
| $B_2O_3$ | | 0.0 | 0.0 | 0.0 | 0.0 | 0.0 | 0.0 | 7.7 | 7.5 |
| MgO | | 4.1 | 4.1 | 4.1 | 7.0 | 7.0 | 7.0 | 0.0 | 0.0 |
| CaO | | 7.1 | 7.1 | 7.1 | 2.0 | 2.0 | 2.0 | 0.0 | 0.0 |
| SrO | | 0.0 | 0.0 | 0.0 | 0.0 | 0.0 | 0.0 | 0.0 | 0.0 |
| BaO | | 0.0 | 0.0 | 0.0 | 0.0 | 0.0 | 0.0 | 0.0 | 0.0 |
| $Li_2O$ | | 0.0 | 0.0 | 0.0 | 0.0 | 0.0 | 0.0 | 0.0 | 0.0 |
| $Na_2O$ | | 14.5 | 14.5 | 14.5 | 14.0 | 14.0 | 14.0 | 6.6 | 6.5 |
| $K_2O$ | | 0.2 | 0.2 | 0.2 | 0.5 | 0.5 | 0.5 | 6.2 | 6.0 |
| $ZrO_2$ | | 0.0 | 0.0 | 0.0 | 0.0 | 0.0 | 0.0 | 0.0 | 0.0 |
| $TiO_2$ | | 0.00 | 0.00 | 0.00 | 0.0 | 0.0 | 0.0 | 3.9 | 3.9 |
| $CeO_2$ | | 0.8 | 0.6 | 0.4 | 2.0 | 2.0 | 2.0 | 4.0 | 6.0 |
| $Fe_2O_3$ | | 0.55 | 0.88 | 1.21 | 0.50 | 0.50 | 0.50 | 0.00 | 0.00 |
| ZnO | | 0.0 | 0.0 | 0.0 | 0.0 | 0.0 | 0.0 | 4.8 | 4.7 |
| $La_2O_3$ | | 0.0 | 0.0 | 0.0 | 0.0 | 0.0 | 0.0 | 0.0 | 0.0 |
| $Sb_2O_3$ | | 0.0 | 0.0 | 0.0 | 0.0 | 0.0 | 0.0 | 0.0 | 0.0 |
| $SO_3$ | | 0.0 | 0.0 | 0.0 | 0.0 | 0.0 | 0.0 | 0.0 | 0.0 |
| Cl | | 0.0 | 0.0 | 0.0 | 0.0 | 0.0 | 0.0 | 0.0 | 0.0 |
| total | | 100.0 | 100.0 | 100.0 | 100.0 | 100.0 | 100.0 | 100.0 | 100.0 |
| $Na_2O+K_2O$ | | 14.7 | 14.7 | 14.7 | 14.5 | 14.5 | 14.5 | 12.8 | 12.5 |
| $R_2O$ | | 14.7 | 14.7 | 14.7 | 14.5 | 14.5 | 14.5 | 12.8 | 12.5 |
| $Na_2O+MgO$ | | 18.6 | 18.6 | 18.6 | 21.0 | 21.0 | 21.0 | 6.6 | 6.5 |
| $SiO_2+Al_2O_3$ | | 72.7 | 72.6 | 72.5 | 74.0 | 74.0 | 74.0 | 66.8 | 65.4 |
| $CeO_2+SiO_2+Al_2O_3$ | | 72.5 | 73.2 | 72.9 | 76.0 | 76.0 | 76.0 | 70.8 | 71.4 |
| $CeO_2+1/2Al_2O_3+Fe_2O_3$ | | 3.85 | 3.95 | 4.05 | 5.5 | 6.0 | 6.5 | 6.12 | 8.07 |
| $CeO_2+Al_2O_3+Fe_2O_3$ | | 6.3 | 6.4 | 6.5 | 8.50 | 9.50 | 10.50 | 8.23 | 10.14 |
| Wavelength @ 0.1 mm showing transmittance of 2% | nm | 282 | 290 | 296 | 315 | 315 | 315 | 329 | 334 |

(continued)

| wt% | | C-14 | C-15 | C-16 | D-1 | D-2 | D-3 | D-4 | D-5 |
|---|---|---|---|---|---|---|---|---|---|
| Visible light average transmittance (380 nm to 780 nm) @ 0.1 mm | % | 92 | 91 | 91 | 92 | 92 | 92 | 92 | 92 |
| Wavelength @ 0.1 mm showing transmittance of 2% after electron beam irradiation | nm | - | - | - | - | - | - | - | - |
| Visible light average transmittance (380 nm to 780 nm) @ 0.1 mm after electron beam irradiation | % | - | - | - | - | - | - | - | - |
| Wavelength @ 0.1 mm showing transmittance of 2% after UVC irradiation | nm | - | - | - | - | - | - | - | - |
| Visible light average transmittance (380 nm to 780 nm) @ 0.1 mm after ultraviolet ray irradiation | % | - | - | - | - | - | - | - | - |
| Amount of CeO$_2$ in case of converting 0.5 mm to 0.1 mm | | - | - | - | - | - | - | - | - |
| Wavelength @ 0.5 mm showing transmittance of 2% | nm | - | - | - | - | - | - | - | - |
| Visible light average transmittance (380 nm to 780 nm) @ 0.5 mm | % | - | - | - | - | - | - | - | - |
| Wavelength @ 0.5 mm showing transmittance of 2% after electron beam irradiation | nm | - | - | - | - | - | - | - | - |
| Visible light average transmittance (380 nm to 780 nm) @ 0.5 mm after electron beam irradiation | % | - | - | - | - | - | - | - | - |
| Wavelength @ 0.5 mm showing transmittance of 2% after UVA irradiation | nm | - | - | - | - | - | - | - | - |

(continued)

| wt% | | C-14 | C-15 | C-16 | D-1 | D-2 | D-3 | D-4 | D-5 |
|---|---|---|---|---|---|---|---|---|---|
| Visible light average transmittance (380 nm to 780 nm) @ 0.5 mm after UVA irradiation | % | | | | | | | | |
| Wavelength @ 0.5 mm showing transmittance of 2% after UVC irradiation | nm | - | - | - | - | - | - | - | - |
| Visible light average transmittance (380 nm to 780 nm) @ 0.5 mm after UVC irradiation | % | - | - | - | - | - | - | - | - |
| Average thermal expansion coefficient at 50°C to 350°C | $\times 10^{-7}$/°C | - | - | - | - | - | - | - | - |
| Devitrification viscosity (log $\eta$) | dPa·s | 5.1 | 5.2 | 5.3 | - | - | - | - | - |
| Melting temperature $T_2$ | °C | 1470 | 1469 | 1468 | - | - | - | - | - |
| Chemical strengthening property CS | MPa | 730 | 723 | 717 | 680 | 710 | 740 | - | - |
| Chemical strengthening property DOL | $\mu$m | 15 | 15 | 15 | 32 | 32 | 32 | - | - |
| Acid resistance | mg/cm$^2$ | - | - | - | - | - | - | - | - |
| Specific gravity | g/cm$^3$ | 2.52 | 2.53 | 2.53 | - | - | - | - | - |
| Young's modulus | GPa | 75 | 75 | 75 | - | - | - | - | - |

[Table 10]

| wt% | C-17 | C-18 | C-19 | C-20 | C-21 | C-22 | C-23 |
|---|---|---|---|---|---|---|---|
| $SiO_2$ | 67.3 | 67.2 | 65.2 | 63.9 | 59.7 | 64.8 | 61.7 |
| $Al_2O_3$ | 4.9 | 4.9 | 4.7 | 4.6 | 4.3 | 4.7 | 4.5 |
| $B_2O_3$ | 0.0 | 0.0 | 3.0 | 5.0 | 11.0 | 0.0 | 0.0 |
| MgO | 4.0 | 4.0 | 3.9 | 3.8 | 3.6 | 3.9 | 3.7 |
| CaO | 7.1 | 7.1 | 6.9 | 6.7 | 6.3 | 6.9 | 6.6 |
| SrO | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 |
| $Na_2O$ | 14.4 | 14.4 | 13.9 | 13.7 | 12.8 | 13.8 | 13.1 |
| $K_2O$ | 0.2 | 0.2 | 0.2 | 0.2 | 0.2 | 0.4 | 0.4 |
| $ZrO_2$ | 0.0 | 0.0 | 0.0 | 0.0 | 0.0 | 0.0 | 0.0 |
| $TiO_2$ | 0.0 | 0.0 | 0.0 | 0.0 | 0.0 | 0.0 | 0.0 |
| $CeO_2$ | 2.0 | 2.0 | 2.0 | 2.0 | 2.0 | 5.5 | 10.0 |

(continued)

| wt% | | C-17 | C-18 | C-19 | C-20 | C-21 | C-22 | C-23 |
|---|---|---|---|---|---|---|---|---|
| $Fe_2O_3$ | | 0.1 | 0.1 | 0.1 | 0.1 | 0.1 | 0.0 | 0.0 |
| NiO | | 0.05 | 0.10 | 0.0 | 0.0 | 0.0 | 0.0 | 0.0 |
| ZnO | | 0.0 | 0.0 | 0.0 | 0.0 | 0.0 | 0.0 | 0.0 |
| $La_2O_3$ | | 0.0 | 0.0 | 0.0 | 0.0 | 0.0 | 0.0 | 0.0 |
| $Sb_2O_3$ | | 0.0 | 0.0 | 0.0 | 0.0 | 0.0 | 0.0 | 0.0 |
| $SO_3$ | | 0.0 | 0.0 | 0.0 | 0.0 | 0.0 | 0.0 | 0.0 |
| Cl | | 0.0 | 0.0 | 0.0 | 0.0 | 0.0 | 0.0 | 0.0 |
| total | | 100.0 | 100.0 | 100.0 | 100.0 | 100.0 | 100.0 | 100.0 |
| $Na_2O+K_2O$ | | 14.6 | 14.6 | 14.2 | 13.9 | 13.0 | 14.2 | 13.5 |
| $R_2O$ | | 14.6 | 14.6 | 14.2 | 13.9 | 13.0 | 14.2 | 13.5 |
| $Na_2O+MgO$ | | 18.4 | 18.4 | 17.9 | 17.5 | 16.4 | 17.7 | 16.8 |
| $SiO_2+Al_2O_3$ | | 72.1 | 72.1 | 70.0 | 68.5 | 64.1 | 69.5 | 66.2 |
| $CeO_2+SiO_2+Al_2O_3$ | | 74.1 | 74.1 | 72.0 | 70.5 | 66.1 | 75.0 | 76.2 |
| $CeO_2+1/2Al_2O_3+Fe_2O_3$ | | 4.51 | 4.51 | 4.44 | 4.39 | 4.23 | 7.86 | 12.25 |
| $CeO_2+Al_2O_3+Fe_2O_3$ | | 6.9 | 6.9 | 6.8 | 6.7 | 6.4 | 10.2 | 14.5 |
| Wavelength @ 0.1 mm showing transmittance of 2% | nm | 334 | 341 | 323 | 323 | 320 | 320 | 322 |
| Visible light average transmittance (380 nm to 780 nm) @ 0.1 mm | % | 91.1 | 89.6 | 91.6 | 91.5 | 91.5 | 90.9 | 90.3 |
| Wavelength @ 0.1 mm showing transmittance of 2% after electron beam irradiation | nm | - | - | - | - | - | - | - |
| Visible light average transmittance (380 nm to 780 nm) @ 0.1 mm after electron beam irradiation | % | - | - | - | - | - | - | - |
| Wavelength @ 0.1 mm showing transmittance of 2% after UVC irradiation | nm | - | - | - | - | - | - | - |
| Visible light average transmittance (380 nm to 780 nm) @ 0.1 mm after ultraviolet ray irradiation | % | - | - | - | - | - | - | - |
| Amount of $CeO_2$ in case of converting 0.5 mm to 0.1 mm | wt% | - | - | - | - | - | - | - |
| Wavelength @ 0.5 mm showing transmittance of 2% | nm | | | | | | | |
| Visible light average transmittance (380 nm to 780 nm) @ 0.5 mm | % | - | - | - | - | - | - | - |
| Wavelength @ 0.5 mm showing transmittance of 2% after electron beam irradiation | nm | - | - | - | - | - | - | - |

(continued)

| wt% | | C-17 | C-18 | C-19 | C-20 | C-21 | C-22 | C-23 |
|---|---|---|---|---|---|---|---|---|
| Visible light average transmittance (380 nm to 780 nm) @ 0.5 mm after electron beam irradiation | % | - | - | - | - | - | - | - |
| Wavelength @ 0.5 mm showing transmittance of 2% after UVA irradiation | nm | - | - | - | - | - | - | - |
| Visible light average transmittance (380 nm to 780 nm) @ 0.5 mm after UVA irradiation | % | - | - | - | - | - | - | - |
| Wavelength @ 0.5 mm showing transmittance of 2% after UVC irradiation | nm | - | - | - | - | - | - | - |
| Visible light average transmittance (380 nm to 780 nm) @ 0.5 mm after UVC irradiation | % | - | - | - | - | - | - | - |
| Average thermal expansion coefficient at 50°C to 350°C | $\times 10^{-7}$/°C | - | - | - | - | - | - | - |
| Devitrification viscosity (log $\eta$) | dPa·s | 4.7 | 4.7 | 4.7 | 4.7 | 4.7 | 3.3 | 2.8 |
| Melting temperature $T_2$ | °C | 1466 | 1466 | 1466 | 1466 | 1467 | 1445 | 1427 |
| Chemical strengthening property CS | MPa | 713 | 713 | 713 | 713 | 713 | 713 | 713 |
| Chemical strengthening property DOL | $\mu$m | 15 | 15 | 14 | 13 | 12 | 15 | 15 |
| Acid resistance | mg/cm$^2$ | - | - | 0.001 | 0.05 | 0.45 | - | - |
| Specific gravity | g/cm$^3$ | 2.54 | 2.54 | 2.54 | 2.54 | 2.53 | 2.60 | 2.66 |
| Young's modulus | GPa | 75 | 75 | 75 | 75 | 75 | 76 | 78 |

[Table 11]

| mol% | A-1 | A-2 | A-3 | A-4 | A-5 | A-6 | A-7 | A-8 | A-9 | A-10 | A-11 |
|---|---|---|---|---|---|---|---|---|---|---|---|
| SiO$_2$ | 66.8 | 64.6 | 64.0 | 63.9 | 63.9 | 63.9 | 63.9 | 63.8 | 64.4 | 64.4 | 64.3 |
| Al$_2$O$_3$ | 6.0 | 5.8 | 7.9 | 7.9 | 7.9 | 7.9 | 7.9 | 7.9 | 8.0 | 8.0 | 8.0 |
| B$_2$O$_3$ | 0.0 | 0.0 | 0.0 | 0.0 | 0.0 | 0.0 | 0.0 | 0.0 | 0.0 | 0.0 | 0.0 |
| MgO | 10.5 | 10.1 | 10.4 | 10.4 | 10.4 | 10.4 | 10.4 | 10.4 | 10.5 | 10.5 | 10.5 |
| CaO | 0.1 | 0.1 | 0.0 | 0.0 | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 | 0.0 | 0.0 | 0.0 | 0.0 |
| Li$_2$O | 0.0 | 0.0 | 0.0 | 0.0 | 0.0 | 0.0 | 0.0 | 0.0 | 0.0 | 0.0 | 0.0 |
| Na$_2$O | 12.5 | 12.1 | 12.4 | 12.4 | 12.4 | 12.4 | 12.4 | 12.4 | 12.5 | 12.5 | 12.5 |
| K$_2$O | 4.0 | 3.9 | 4.0 | 4.0 | 4.0 | 4.0 | 4.0 | 4.0 | 4.0 | 4.0 | 4.0 |
| ZrO$_2$ | 0.0 | 0.0 | 0.5 | 0.5 | 0.5 | 0.5 | 0.5 | 0.5 | 0.5 | 0.5 | 0.5 |
| TiO$_2$ | 0.00 | 0.00 | 0.04 | 0.04 | 0.04 | 0.04 | 0.04 | 0.04 | 0.04 | 0.04 | 0.04 |
| CeO$_2$ | 0.2 | 3.5 | 0.5 | 0.5 | 0.7 | 0.7 | 0.5 | 0.7 | 0.1 | 0.2 | 0.2 |

(continued)

| mol% | A-1 | A-2 | A-3 | A-4 | A-5 | A-6 | A-7 | A-8 | A-9 | A-10 | A-11 |
|---|---|---|---|---|---|---|---|---|---|---|---|
| $Fe_2O_3$ | 0.00 | 0.00 | 0.33 | 0.29 | 0.24 | 0.20 | 0.33 | 0.33 | 0.00 | 0.00 | 0.00 |
| $ZnO$ | 0.0 | 0.0 | 0.0 | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 | 0.0 | 0.0 | 0.0 |
| $Cl$ | 0.0 | 0.0 | 0.0 | 0.0 | 0.0 | 0.0 | 0.0 | 0.0 | 0.0 | 0.0 | 0.0 |
| $SnO_2$ | 0.0 | 0.0 | 0.0 | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 | 100.0 | 100.0 | 100.0 |
| $Na_2O+K_2O$ | 16.5 | 15.9 | 16.4 | 16.4 | 16.3 | 16.3 | 16.3 | 16.3 | 16.5 | 16.5 | 16.5 |
| $R_2O$ | 16.5 | 15.9 | 16.4 | 16.4 | 16.3 | 16.3 | 16.3 | 16.3 | 16.5 | 16.5 | 16.5 |
| $Na_2O+MgO$ | 22.9 | 22.2 | 22.8 | 22.8 | 22.8 | 22.8 | 22.8 | 22.8 | 23.0 | 22.9 | 22.9 |
| $SiO_2+Al_2O_3$ | 72.7 | 70.4 | 71.9 | 71.9 | 71.8 | 71.8 | 71.8 | 71.8 | 72.4 | 72.3 | 72.3 |
| $CeO_2+SiO_2+Al_2O_3$ | 73.0 | 73.8 | 72.4 | 72.4 | 72.5 | 72.5 | 72.4 | 72.4 | 72.5 | 72.5 | 72.5 |
| $CeO_2+1/2Al_2O_3+Fe_2O_3$ | 3.21 | 6.38 | 4.77 | 4.81 | 4.85 | 4.89 | 4.84 | 4.95 | 4.14 | 4.18 | 4.21 |
| $CeO_2+Al_2O_3+Fe_2O_3$ | 6.20 | 9.27 | 8.74 | 8.77 | 8.82 | 8.85 | 8.81 | 8.91 | 8.13 | 8.17 | 8.20 |

[Table 12]

| mol% | A-12 | A-13 | A-14 | A-15 | A-16 | A-17 | A-18 | A-19 | A-20 | A-21 | A-22 |
|---|---|---|---|---|---|---|---|---|---|---|---|
| $SiO_2$ | 64.3 | 64.2 | 63.5 | 63.4 | 63.1 | 63.2 | 63.1 | 63.9 | 63.6 | 64.5 | 64.4 |
| $Al_2O_3$ | 8.0 | 8.0 | 7.9 | 7.9 | 7.8 | 7.8 | 7.8 | 7.9 | 7.9 | 8.0 | 8.0 |
| $B_2O_3$ | 0.0 | 0.0 | 0.0 | 0.0 | 0.0 | 0.0 | 0.0 | 0.0 | 0.0 | 0.0 | 0.0 |
| $MgO$ | 10.5 | 10.4 | 10.3 | 10.3 | 10.3 | 10.3 | 10.3 | 10.4 | 10.4 | 10.5 | 10.5 |
| $CaO$ | 0.0 | 0.0 | 0.0 | 0.0 | 0.1 | 0.0 | 0.0 | 0.0 | 0.0 | 0.0 | 0.0 |
| $SrO$ | 0.0 | 0.0 | 0.0 | 0.0 | 0.0 | 0.0 | 0.0 | 0.0 | 0.0 | 0.0 | 0.0 |
| $BaO$ | 0.0 | 0.0 | 0.0 | 0.0 | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 | 0.0 | 0.0 | 0.0 | 0.0 |
| $Na_2O$ | 12.5 | 12.4 | 12.3 | 12.3 | 12.3 | 12.2 | 12.2 | 12.4 | 12.3 | 12.5 | 12.5 |
| $K_2O$ | 4.0 | 4.0 | 3.9 | 3.9 | 3.9 | 3.9 | 3.9 | 4.0 | 3.9 | 4.0 | 4.0 |
| $ZrO_2$ | 0.5 | 0.5 | 0.5 | 0.5 | 0.5 | 0.5 | 0.5 | 0.5 | 0.5 | 0.5 | 0.5 |
| $TiO_2$ | 0.04 | 0.04 | 0.04 | 0.04 | 0.04 | 0.04 | 0.04 | 0.04 | 0.04 | 0.00 | 0.04 |
| $CeO_2$ | 0.3 | 0.5 | 1.4 | 1.6 | 1.9 | 2.0 | 2.2 | 0.2 | 0.2 | 0.0 | 0.1 |
| $Fe_2O_3$ | 0.00 | 0.00 | 0.00 | 0.00 | 0.00 | 0.00 | 0.00 | 0.78 | 1.17 | 0.00 | 0.00 |
| $ZnO$ | 0.0 | 0.0 | 0.0 | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 | 0.0 | 0.0 | 0.0 |
| $Cl$ | 0.0 | 0.0 | 0.0 | 0.0 | 0.0 | 0.0 | 0.0 | 0.0 | 0.0 | 0.0 | 0.0 |
| $SnO_2$ | 0.0 | 0.0 | 0.0 | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 | 100.0 | 100.0 | 100.0 |

(continued)

| mol% | A-12 | A-13 | A-14 | A-15 | A-16 | A-17 | A-18 | A-19 | A-20 | A-21 | A-22 |
|---|---|---|---|---|---|---|---|---|---|---|---|
| $Na_2O+K_2O$ | 16.5 | 16.4 | 16.3 | 16.2 | 16.2 | 16.2 | 16.1 | 16.3 | 16.3 | 16.5 | 16.5 |
| $R_2O$ | 16.5 | 16.4 | 16.3 | 16.2 | 16.2 | 16.2 | 16.1 | 16.3 | 16.3 | 16.5 | 16.5 |
| $Na_2O+MgO$ | 22.9 | 22.9 | 22.7 | 22.6 | 22.6 | 22.5 | 22.5 | 22.8 | 22.7 | 23.0 | 23.0 |
| $SiO_2+Al_2O_3$ | 72.3 | 72.1 | 71.4 | 71.3 | 71.0 | 71.0 | 70.9 | 71.8 | 71.5 | 72.5 | 72.4 |
| $CeO_2+SiO_2+Al_2O_3$ | 72.5 | 72.6 | 72.9 | 72.9 | 72.9 | 73.0 | 73.1 | 72.0 | 71.7 | 72.5 | 72.5 |
| $CeO_2+1/2Al_2O_3+Fe_2O_3$ | 4.25 | 4.46 | 5.39 | 5.56 | 5.82 | 5.90 | 6.07 | 4.93 | 5.30 | 4.00 | 4.11 |
| $CeO_2+Al_2O_3+Fe_2O_3$ | 8.24 | 8.44 | 9.33 | 9.50 | 9.75 | 9.82 | 9.98 | 8.89 | 9.24 | 8.00 | 8.10 |

[Table 13]

| mol% | B-1 | B-2 | B-3 | B-4 | B-5 | B-6 | B-7 | B-8 | B-9 | B-10 | B-11 |
|---|---|---|---|---|---|---|---|---|---|---|---|
| $SiO_2$ | 63.7 | 63.7 | 63.8 | 63.7 | 63.6 | 63.5 | 63.7 | 63.9 | 64.1 | 64.0 | 63.0 |
| $Al_2O_3$ | 10.3 | 10.3 | 10.4 | 10.3 | 10.3 | 10.3 | 10.4 | 10.4 | 10.4 | 10.4 | 10.2 |
| $B_2O_3$ | 0.0 | 0.0 | 0.0 | 0.0 | 0.0 | 0.0 | 0.0 | 0.0 | 0.0 | 0.0 | 0.0 |
| $MgO$ | 8.2 | 8.2 | 8.2 | 8.2 | 8.2 | 8.2 | 8.2 | 8.3 | 8.3 | 8.3 | 8.1 |
| $CaO$ | 0.0 | 0.0 | 0.0 | 0.0 | 0.0 | 0.0 | 0.0 | 0.0 | 0.0 | 0.0 | 0.0 |
| $SrO$ | 0.0 | 0.0 | 0.0 | 0.0 | 0.0 | 0.0 | 0.0 | 0.0 | 0.0 | 0.0 | 0.0 |
| $BaO$ | 0.0 | 0.0 | 0.0 | 0.0 | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 | 0.0 | 0.0 | 0.0 | 0.0 |
| $Na_2O$ | 15.8 | 15.8 | 15.9 | 15.8 | 15.8 | 15.8 | 15.9 | 15.9 | 16.0 | 15.9 | 15.7 |
| $K_2O$ | 0.8 | 0.8 | 0.8 | 0.8 | 0.8 | 0.8 | 0.8 | 0.8 | 0.8 | 0.8 | 0.8 |
| $ZrO_2$ | 0.1 | 0.1 | 0.1 | 0.1 | 0.1 | 0.1 | 0.1 | 0.1 | 0.1 | 0.1 | 0.1 |
| $TiO_2$ | 0.47 | 0.24 | 0.04 | 0.04 | 0.04 | 0.04 | 0.04 | 0.04 | 0.04 | 0.04 | 0.04 |
| $CeO_2$ | 0.5 | 0.7 | 0.7 | 0.8 | 0.8 | 0.8 | 0.5 | 0.2 | 0.0 | 0.0 | 1.9 |
| $Fe_2O_3$ | 0.02 | 0.02 | 0.00 | 0.20 | 0.34 | 0.40 | 0.34 | 0.34 | 0.20 | 0.40 | 0.00 |
| $ZnO$ | 0.0 | 0.0 | 0.0 | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 | 0.0 | 0.0 | 0.0 |
| $Cl$ | 0.0 | 0.0 | 0.0 | 0.0 | 0.0 | 0.0 | 0.0 | 0.0 | 0.0 | 0.0 | 0.0 |
| $SnO_2$ | 0.0 | 0.0 | 0.0 | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 | 100.0 | 100.0 | 100.0 |
| $Na_2O+K_2O$ | 16.6 | 16.6 | 16.7 | 16.6 | 16.6 | 16.6 | 16.7 | 16.7 | 16.8 | 16.7 | 16.5 |
| $R_2O$ | 16.6 | 16.6 | 16.7 | 16.6 | 16.6 | 16.6 | 16.7 | 16.7 | 16.8 | 16.7 | 16.5 |
| $Na_2O+MgO$ | 24.1 | 24.1 | 24.1 | 24.1 | 24.0 | 24.0 | 24.1 | 24.2 | 24.2 | 24.2 | 23.8 |
| $SiO_2+Al_2O_3$ | 74.0 | 74.0 | 74.2 | 74.0 | 73.9 | 73.9 | 74.1 | 74.3 | 74.6 | 74.4 | 73.3 |
| $CeO_2+SiO_2+Al_2O_3$ | 74.5 | 74.7 | 74.9 | 74.8 | 74.7 | 74.6 | 74.6 | 74.5 | 74.6 | 74.4 | 75.2 |
| $CeO_2+1/2Al_2O_3+Fe_2O_3$ | 5.67 | 5.90 | 5.93 | 6.12 | 6.26 | 6.31 | 6.01 | 5.72 | 5.41 | 5.60 | 7.03 |
| $CeO_2+Al_2O_3+Fe_2O_3$ | 10.84 | 11.08 | 11.12 | 11.30 | 11.43 | 11.48 | 11.19 | 10.92 | 10.62 | 10.80 | 12.15 |

[Table 14]

| mol% | B-12 | B-13 | B-14 | B-15 | B-16 | B-17 | B-18 | B-19 | B-20 |
|---|---|---|---|---|---|---|---|---|---|
| $SiO_2$ | 61.7 | 63.7 | 64.0 | 64.3 | 64.3 | 64.2 | 64.2 | 64.0 | 64.0 |
| $Al_2O_3$ | 10.0 | 10.3 | 10.4 | 10.5 | 10.4 | 10.4 | 10.4 | 10.4 | 10.4 |
| $B_2O_3$ | 0.0 | 0.0 | 0.0 | 0.0 | 0.0 | 0.0 | 0.0 | 0.0 | 0.0 |
| MgO | 8.0 | 8.2 | 8.3 | 8.3 | 8.3 | 8.3 | 8.3 | 8.3 | 8.3 |
| CaO | 0.0 | 0.0 | 0.0 | 0.0 | 0.0 | 0.0 | 0.0 | 0.0 | 0.0 |
| SrO | 0.0 | 0.0 | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 | 0.0 | 0.0 |
| $Na_2O$ | 15.4 | 15.8 | 15.9 | 16.0 | 16.0 | 16.0 | 16.0 | 15.9 | 15.9 |
| $K_2O$ | 0.8 | 0.8 | 0.8 | 0.8 | 0.8 | 0.8 | 0.8 | 0.8 | 0.8 |
| $ZrO_2$ | 0.1 | 0.1 | 0.149 | 0.2 | 0.150 | 0.150 | 0.150 | 0.1 | 0.1 |
| $TiO_2$ | 0.04 | 0.54 | 0.04 | 0.00 | 0.04 | 0.04 | 0.04 | 0.40 | 0.40 |
| $CeO_2$ | 3.9 | 0.2 | 0.5 | 0.0 | 0.0 | 0.0 | 0.1 | 0.1 | 0.1 |
| $Fe_2O_3$ | 0.00 | 0.27 | 0.00 | 0.00 | 0.00 | 0.00 | 0.00 | 0.00 | 0.00 |
| ZnO | 0.0 | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 | 0.0 |
| Cl | 0.0 | 0.0 | 0.0 | 0.0 | 0.0 | 0.0 | 0.0 | 0.0 | 0.0 |
| $SnO_2$ | 0.0 | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 | 100.0 |
| $Na_2O+K_2O$ | 16.1 | 16.6 | 16.7 | 16.8 | 16.8 | 16.8 | 16.8 | 16.7 | 16.7 |
| $R_2O$ | 16.1 | 16.6 | 16.7 | 16.8 | 16.8 | 16.8 | 16.8 | 16.7 | 16.7 |
| $Na_2O+MgO$ | 23.3 | 24.1 | 24.2 | 24.3 | 24.3 | 24.3 | 24.3 | 24.2 | 24.2 |
| $SiO_2+Al_2O_3$ | 71.8 | 74.0 | 74.3 | 74.8 | 74.7 | 74.7 | 74.6 | 74.4 | 74.4 |
| $CeO_2+SiO_2+Al_2O_3$ | 75.7 | 74.2 | 74.8 | 74.8 | 74.7 | 74.7 | 74.7 | 74.5 | 74.5 |
| $CeO_2+1/2Al_2O_3+Fe_2O_3$ | 8.96 | 5.60 | 5.70 | 5.23 | 5.24 | 5.27 | 5.32 | 5.25 | 5.30 |
| $CeO_2+Al_2O_3+Fe_2O_3$ | 13.98 | 10.78 | 10.89 | 10.45 | 10.46 | 10.49 | 10.54 | 10.46 | 10.50 |

[Table 15]

| mol% | C-1 | C-2 | C-3 | C-4 | C-5 | C-6 | C-7 | C-8 |
|---|---|---|---|---|---|---|---|---|
| $SiO_2$ | 68.1 | 68.1 | 67.3 | 68.1 | 68.1 | 68.4 | 68.4 | 68.8 |
| $Al_2O_3$ | 2.9 | 2.9 | 2.9 | 2.9 | 2.9 | 2.9 | 2.9 | 2.9 |
| $B_2O_3$ | 0.0 | 0.0 | 0.0 | 0.0 | 0.0 | 0.0 | 0.0 | 0.0 |
| MgO | 6.1 | 6.1 | 6.0 | 6.1 | 6.1 | 6.1 | 6.1 | 6.2 |
| CaO | 7.7 | 7.7 | 7.7 | 7.7 | 7.7 | 7.7 | 7.7 | 7.7 |
| SrO | 0.0 | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 | 0.0 |

(continued)

| mol% | C-1 | C-2 | C-3 | C-4 | C-5 | C-6 | C-7 | C-8 |
|---|---|---|---|---|---|---|---|---|
| $Na_2O$ | 14.1 | 14.1 | 13.9 | 14.1 | 14.1 | 14.2 | 14.2 | 14.2 |
| $K_2O$ | 0.2 | 0.2 | 0.3 | 0.2 | 0.2 | 0.2 | 0.2 | 0.2 |
| $ZrO_2$ | 0.0 | 0.0 | 0.0 | 0.0 | 0.0 | 0.0 | 0.0 | 0.0 |
| $TiO_2$ | 0.00 | 0.24 | 0.04 | 0.47 | 0.54 | 0.00 | 0.04 | 0.00 |
| $CeO_2$ | 1.0 | 0.7 | 1.8 | 0.5 | 0.2 | 0.5 | 0.5 | 0.0 |
| $Fe_2O_3$ | 0.00 | 0.02 | 0.03 | 0.02 | 0.27 | 0.03 | 0.03 | 0.03 |
| $ZnO$ | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 |
| $Sb_2O_3$ | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 |
| $Cl$ | 0.0 | 0.0 | 0.0 | 0.0 | 0.0 | 0.0 | 0.0 | 0.0 |
| $SnO_2$ | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 |
| $Na_2O+K_2O$ | 14.3 | 14.3 | 14.2 | 14.3 | 14.3 | 14.3 | 14.3 | 14.4 |
| $R_2O$ | 14.3 | 14.3 | 14.2 | 14.3 | 14.3 | 14.3 | 14.3 | 14.4 |
| $Na_2O+MgO$ | 20.2 | 20.2 | 19.9 | 20.2 | 20.2 | 20.3 | 20.3 | 20.4 |
| $SiO_2+Al_2O_3$ | 71.0 | 71.0 | 70.2 | 71.0 | 71.0 | 71.3 | 71.3 | 71.7 |
| $CeO_2+SiO_2+Al_2O_3$ | 72.0 | 71.7 | 72.0 | 71.5 | 71.2 | 71.8 | 71.8 | 71.7 |
| $CeO_2+1/2Al_2O_3+Fe_2O_3$ | 2.42 | 2.18 | 3.29 | 1.94 | 1.88 | 1.99 | 1.99 | 1.50 |
| $CeO_2+Al_2O_3+Fe_2O_3$ | 3.87 | 3.63 | 4.74 | 3.40 | 3.33 | 3.45 | 3.45 | 2.96 |

[Table 16]

| mol% | C-9 | C-10 | C-11 | C-12 | C-13 | C-14 | C-15 | C-16 | D-1 | D-2 | D-3 | D-4 | D-5 |
|---|---|---|---|---|---|---|---|---|---|---|---|---|---|
| $SiO_2$ | 68.1 | 68.7 | 68.7 | 68.1 | 68.5 | 68.4 | 68.4 | 68.3 | 68.8 | 68.0 | 67.3 | 69.6 | 69.0 |
| $Al_2O_3$ | 2.9 | 2.9 | 2.9 | 2.9 | 2.9 | 2.9 | 2.9 | 2.9 | 3.6 | 4.2 | 4.8 | 2.8 | 2.8 |
| $B_2O_3$ | 0.0 | 0.0 | 0.0 | 0.0 | 0.0 | 0.0 | 0.0 | 0.0 | 0.0 | 0.0 | 0.0 | 7.4 | 7.3 |
| $MgO$ | 6.1 | 6.2 | 6.2 | 6.1 | 6.1 | 6.1 | 6.1 | 6.1 | 10.6 | 10.6 | 10.6 | 0.0 | 0.0 |
| $CaO$ | 7.7 | 7.7 | 7.7 | 7.7 | 7.7 | 7.7 | 7.7 | 7.7 | 2.2 | 2.2 | 2.2 | 0.0 | 0.0 |
| $SrO$ | 0.0 | 0.0 | 0.0 | 0.0 | 0.0 | 0.0 | 0.0 | 0.0 | 0.0 | 0.0 | 0.0 | 0.0 | 0.0 |
| $BaO$ | 0.0 | 0.0 | 0.0 | 0.0 | 0.0 | 0.0 | 0.0 | 0.0 | 0.0 | 0.0 | 0.0 | 0.0 | 0.0 |
| $Li_2O$ | 0.0 | 0.0 | 0.0 | 0.0 | 0.0 | 0.0 | 0.0 | 0.0 | 0.0 | 0.0 | 0.0 | 0.0 | 0.0 |
| $Na_2O$ | 14.1 | 14.2 | 14.2 | 14.1 | 14.2 | 14.2 | 14.2 | 14.2 | 13.7 | 13.8 | 13.8 | 7.2 | 7.1 |
| $K_2O$ | 0.2 | 0.2 | 0.2 | 0.2 | 0.2 | 0.2 | 0.2 | 0.2 | 0.3 | 0.3 | 0.3 | 4.4 | 4.3 |
| $ZrO_2$ | 0.0 | 0.0 | 0.0 | 0.0 | 0.0 | 0.0 | 0.0 | 0.0 | 0.0 | 0.0 | 0.0 | 0.0 | 0.0 |
| $TiO_2$ | 0.00 | 0.04 | 0.04 | 0.00 | 0.00 | 0.00 | 0.00 | 0.00 | 0.00 | 0.00 | 0.00 | 3.30 | 3.28 |
| $CeO_2$ | 0.0 | 0.0 | 0.1 | 0.7 | 0.3 | 0.3 | 0.2 | 0.1 | 0.7 | 0.7 | 0.7 | 1.5 | 2.2 |
| $Fe_2O_3$ | 0.97 | 0.03 | 0.03 | 0.22 | 0.08 | 0.21 | 0.33 | 0.46 | 0.19 | 0.19 | 0.19 | 0.00 | 0.00 |
| $ZnO$ | 0.0 | 0.0 | 0.0 | 0.0 | 0.0 | 0.0 | 0.0 | 0.0 | 0.0 | 0.0 | 0.0 | 0.0 | 0.0 |
| $La_2O_3$ | 0.0 | 0.0 | 0.0 | 0.0 | 0.0 | 0.0 | 0.0 | 0.0 | 0.0 | 0.0 | 0.0 | 4.0 | 3.9 |
| $Sb_2O_3$ | 0.0 | 0.0 | 0.0 | 0.0 | 0.0 | 0.0 | 0.0 | 0.0 | 0.0 | 0.0 | 0.0 | 0.0 | 0.0 |
| $SO_3$ | 0.0 | 0.0 | 0.0 | 0.0 | 0.0 | 0.0 | 0.0 | 0.0 | 0.0 | 0.0 | 0.0 | 0.0 | 0.0 |
| $Cl$ | 0.0 | 0.0 | 0.0 | 0.0 | 0.0 | 0.0 | 0.0 | 0.0 | 0.0 | 0.0 | 0.0 | 0.0 | 0.0 |
| $SnO_2$ | 0.0 | 0.0 | 0.0 | 0.0 | 0.0 | 0.0 | 0.0 | 0.0 | 0.0 | 0.0 | 0.0 | 0.0 | 0.0 |
| total | 100.0 | 100.0 | 100.0 | 100.0 | 100.0 | 100.0 | 100.0 | 100.0 | 100.0 | 100.0 | 100.0 | 100.0 | 100.0 |
| $Na_2O+K_2O$ | 14.3 | 14.4 | 14.4 | 14.3 | 14.4 | 14.4 | 14.4 | 14.4 | 14.0 | 14.1 | 14.2 | 11.5 | 11.4 |
| $R_2O$ | 14.3 | 14.4 | 14.4 | 14.3 | 14.4 | 14.4 | 14.4 | 14.4 | 14.0 | 14.1 | 14.2 | 11.5 | 11.4 |
| $Na_2O+MgO$ | 20.2 | 20.4 | 20.4 | 20.2 | 20.3 | 20.3 | 20.3 | 20.3 | 24.3 | 24.4 | 24.5 | 7.2 | 7.1 |
| $SiO_2+Al_2O_3$ | 71.0 | 71.6 | 71.6 | 71 | 71.4 | 71.3 | 71.3 | 71.2 | 72.3 | 72.2 | 72.1 | 72.4 | 71.8 |
| $CeO_2+SiO_2+Al_2O_3$ | 71.0 | 71.6 | 71.7 | 71.689 | 71.748 | 71.578 | 71.509 | 71.339 | 73.0 | 72.9 | 72.8 | 73.8 | 74.0 |

| mol% | C-9 | C-10 | C-11 | C-12 | C-13 | C-14 | C-15 | C-16 | D-1 | D-2 | D-3 | D-4 | D-5 |
|---|---|---|---|---|---|---|---|---|---|---|---|---|---|
| $CeO_2+1/2Al_2O_3+Fe_2O_3$ | 2.42 | 1.51 | 1.55 | 2.363 | 1.881 | 1.938 | 1.992 | 2.05 | 2.68 | 2.99 | 3.31 | 2.86 | 3.62 |
| $CeO_2+Al_2O_3+Fe_2O_3$ | 3.87 | 2.97 | 3.01 | 3.813 | 3.331 | 3.388 | 3.442 | 3.5 | 4.47 | 5.09 | 5.71 | 4.25 | 5.00 |

EP 4 692 007 A1

[Table 17]

| mol% | | C-17 | C-18 | C-19 | C-20 | C-21 | C-22 | C-23 |
|---|---|---|---|---|---|---|---|---|
| $SiO_2$ | | 68.2 | 68.2 | 66.4 | 65.2 | 61.5 | 67.2 | 66.1 |
| $Al_2O_3$ | | 2.9 | 2.9 | 2.8 | 2.8 | 2.6 | 2.9 | 2.8 |
| $B_2O_3$ | | 0.0 | 0.0 | 2.6 | 4.4 | 9.8 | | |
| MgO | | 6.1 | 6.1 | 6.0 | 5.8 | 5.5 | 6.0 | 5.9 |
| CaO | | 7.7 | 7.7 | 7.5 | 7.4 | 6.9 | 7.7 | 7.5 |
| SrO | | 0.0 | 0.0 | 0.0 | 0.0 | 0.0 | 0.0 | 0.0 |
| BaO | | 0.0 | 0.0 | 0.0 | 0.0 | 0.0 | 0.0 | 0.0 |
| $Li_2O$ | | 0.0 | 0.0 | 0.0 | 0.0 | 0.0 | 0.0 | 0.0 |
| $Na_2O$ | | 14.1 | 14.1 | 13.8 | 13.5 | 12.7 | 13.9 | 13.6 |
| $K_2O$ | | 0.2 | 0.2 | 0.1 | 0.1 | 0.1 | 0.3 | 0.2 |
| $ZrO_2$ | | 0.0 | 0.0 | 0.0 | 0.0 | 0.0 | 0.0 | 0.0 |
| $TiO_2$ | | 0.0 | 0.0 | 0.0 | 0.0 | 0.0 | 0.0 | 0.0 |
| $CeO_2$ | | 0.7 | 0.7 | 0.7 | 0.7 | 0.7 | 2.0 | 3.7 |
| $Fe_2O_3$ | | 0.03 | 0.03 | 0.03 | 0.03 | 0.03 | 0.00 | 0.00 |
| NiO | | 0.04 | 0.08 | 0.00 | 0.00 | 0.00 | 0.00 | 0.00 |
| ZnO | | 0.0 | 0.0 | 0.0 | 0.0 | 0.0 | 0.0 | 0.0 |
| $La_2O_3$ | | 0.0 | 0.0 | 0.0 | 0.0 | 0.0 | 0.0 | 0.0 |
| $Sb_2O_3$ | | 0.0 | 0.0 | 0.0 | 0.0 | 0.0 | 0.0 | 0.0 |
| $SO_3$ | | 0.0 | 0.0 | 0.0 | 0.0 | 0.0 | 0.0 | 0.0 |
| Cl | | 0.0 | 0.0 | 0.0 | 0.0 | 0.0 | 0.0 | 0.0 |
| total | | 100.0 | 100.0 | 100.0 | 100.0 | 100.0 | 100.0 | 100.0 |
| $Na_2O+K_2O$ | | 14.3 | 14.3 | 13.9 | 13.7 | 12.9 | 14.1 | 13.9 |
| $R_2O$ | | 14.3 | 14.3 | 13.9 | 13.7 | 12.9 | 14.1 | 13.9 |
| $Na_2O+MgO$ | | 20.3 | 20.2 | 19.7 | 19.4 | 18.3 | 19.9 | 19.5 |
| $SiO_2+Al_2O_3$ | | 71.1 | 71.1 | 69.3 | 68.0 | 64.1 | 70.1 | 68.9 |
| $CeO_2+SiO_2+Al_2O_3$ | | 71.8 | 71.8 | 70.0 | 68.7 | 64.9 | 72.1 | 72.6 |
| $CeO_2+1/2Al_2O_3+Fe_2O_3$ | | 2.19 | 2.19 | 2.16 | 2.13 | 2.06 | 3.44 | 5.16 |
| $CeO_2+Al_2O_3+Fe_2O_3$ | | 3.6 | 3.6 | 3.6 | 3.5 | 3.4 | 4.9 | 6.6 |
| Wavelength @ 0.1 mm showing transmittance of 2% | nm | 334 | 341 | 323 | 323 | 320 | 320 | 322 |
| Visible light average transmittance (380 nm to 780 nm) | % | 91.1 | 89.6 | 91.6 | 91.5 | 91.5 | 90.9 | 90.3 |
| Wavelength @ 0.1 mm showing transmittance of 2% after electron beam irradiation | nm | - | - | - | - | - | - | - |
| Visible light average transmittance (380 nm to 780 nm) @ 0.1 mm after electron beam irradiation | % | - | - | - | - | - | - | - |
| Wavelength @ 0.1 mm showing transmittance of 2% after UVC irradiation | nm | - | - | - | - | - | - | - |

(continued)

| mol% | | C-17 | C-18 | C-19 | C-20 | C-21 | C-22 | C-23 |
|---|---|---|---|---|---|---|---|---|
| Visible light average transmittance (380 nm to 780 nm) @ 0.1 mm after ultraviolet ray irradiation | % | - | - | - | - | - | - | - |
| Amount of $CeO_2$ in case of converting 0.5 mm to 0.1 mm | wt% | - | - | - | - | - | - | - |
| Wavelength @ 0.5 mm showing transmittance of 2% | nm | - | - | - | - | - | - | - |
| Visible light average transmittance (380 nm to 780 nm) @ 0.5 mm | % | - | - | - | - | - | - | - |
| Wavelength @ 0.5 mm showing transmittance of 2% after electron beam irradiation | nm | - | - | - | - | - | - | - |
| Visible light average transmittance (380 nm to 780 nm) @ 0.5 mm after electron beam irradiation | % | - | - | - | - | - | - | - |
| Wavelength @ 0.5 mm showing transmittance of 2% after UVA irradiation | nm | - | - | - | - | - | - | - |
| Visible light average transmittance (380 nm to 780 nm) @ 0.5 mm after UVA irradiation | % | - | - | - | - | - | - | - |
| Wavelength @ 0.5 mm showing transmittance of 2% after UVC irradiation | nm | - | - | - | - | - | - | - |
| Visible light average transmittance (380 nm to 780 nm) @ 0.5 mm after UVC irradiation | % | - | - | - | - | - | - | - |
| Average thermal expansion coefficient at 50°C to 350°C | $\times 10^{-7}$/°C | - | - | - | - | - | - | - |
| Devitrification viscosity (log $\eta$) | dPa·s | 4.7 | 4.7 | 4.7 | 4.7 | 4.7 | 3.3 | 2.8 |
| Melting temperature $T_2$ | °C | 1466 | 1466 | 1466 | 1466 | 1467 | 1445 | 1427 |
| Chemical strengthening property CS | MPa | 713 | 713 | 713 | 713 | 713 | 713 | 713 |
| Chemical strengthening property DOL | $\mu$m | 15 | 15 | 14 | 13 | 12 | 15 | 15 |
| Acid resistance | mg/cm$^2$ | - | - | 0.001 | 0.05 | 0.45 | - | - |
| Specific gravity | g/cm$^3$ | 2.54 | 2.54 | 2.54 | 2.54 | 2.53 | 2.60 | 2.66 |
| Young's modulus | GPa | 75 | 75 | 75 | 75 | 75 | 76 | 78 |

As shown in Tables 1 to 3, it is found that in Examples A-1 to A-20, which are Working Examples, the wavelength (@ 0.1 mm) showing a transmittance of 2% is larger than that in Example A-22, which is a Comparative Example, and an excellent effect of shielding ultraviolet rays is obtained by containing $CeO_2$ in the range of 0.4% to 10%.

In Examples A-21, which is a Comparative Example, since $CeO_2$ is not contained, the wavelength (@ 0.1 mm) showing a transmittance of 2% is as low as less than 210 nm, and the visible light average transmittance (@ 0.1 mm and @ 0.5 mm) after electron beam irradiation is lower than that before the irradiation. From this result, it is found that when $CeO_2$

41

is contained, ultraviolet rays can be effectively shielded, and the coloration due to the electron beam irradiation can be prevented.

In addition, in Examples A-19 and A-20, which are Working Examples, the wavelength showing a transmittance of 2% is 310 nm or more and is larger than that in Example A-10, which is an Inventive Example. From this result, it is found that the effect of shielding ultraviolet rays can be further improved by containing $Fe_2O_3$ in addition to $CeO_2$.

As shown in Tables 4 to 6, it is found that in Examples B-1, B-2, and B-14, which are Working Examples, the wavelength (@ 0.1 mm and @ 0.5 mm) showing a transmittance of 2% is larger than those in Examples B-16 to B-20, which are Comparative Examples, and an excellent effect of shielding ultraviolet rays is obtained by containing $CeO_2$ in the range of 0.4% to 10%. In addition, from the results in Examples B-3 to B-8, which are Working Examples, it is found that the effect of shielding ultraviolet rays can be improved by containing $Fe_2O_3$ in addition to $CeO_2$.

As shown in Tables 7 to 10, it is found that in Examples C-1 to C-7 and C-12 to C-23, which are Working Examples, the wavelength (@ 0.1 mm) showing a transmittance of 2% is larger than that in Examples C-10 and C-11, which are Comparative Examples, and an excellent effect of shielding ultraviolet rays is obtained by containing $CeO_2$.

In addition, in Examples C-6 and C-7, which are Working Examples, the visible light average transmittance (@ 0.5 mm) does not decrease even after the electron beam irradiation and is equivalent to that in Examples C-10 and C-11, which are Comparative Examples. In addition, in Examples C-10 and C-11, which are Comparative Examples, the visible light average transmittance (@ 0.5 mm) after the electron beam irradiation significantly decreases as compared with that in Examples C-6 and C-7, which are Working Examples. From this result, it is found that when $CeO_2$ is contained, ultraviolet rays can be effectively shielded, and the coloration due to the electron beam irradiation can be prevented.

As shown in Table 9, in Examples D-1 to D-3, which are Working Examples, the surface compressive stress is 600 MPa or more when the chemical strengthening treatment was performed at 425°C for 6 hours using a 100 mass% $KNO_3$ salt. From this result, it is found that the glass according to the present embodiment is chemically strengthenable and can have a sufficiently ensured strength even in the case where the size is increased.

Although various embodiments have been described above with reference to the drawings, it is needless to say that the present invention is not limited to such examples. It is obvious for a person skilled in the art that various modifications and variations can be made within the category described in the scope of claims and it is understood that such modifications and variations naturally belong to the technical scope of the present invention. Further, the components described in the above embodiment may be combined in any manner without departing from the spirit of the invention.

Note that, the present application is based on Japanese Patent Application No. 2023-054194 filed on March 29, 2023 and Japanese Patent Application No. 2023-144621 filed on September 6, 2023, the contents of which are incorporated herein by reference.

**Claims**

1. A glass comprising, in terms of mass% based on oxides:

   0.3% to 10% of $CeO_2$;
   45% to 85% of $SiO_2$; and
   0% to 25% of $Al_2O_3$.

2. The glass according to claim 1, comprising, in terms of mass% based on oxides:

   2.0% to 10% of $CeO_2$;
   45% to 85% of $SiO_2$; and
   0% to 7% of $Al_2O_3$.

3. The glass according to claim 1, comprising, in terms of mass% based on oxides: 7.0% to 25% of $Al_2O_3$.

4. The glass according to any one of claims 1 to 3, further comprising, in terms of mass% based on oxides: 0.3% to 3.0% of $Fe_2O_3$.

5. The glass according to any one of claims 1 to 3, wherein the content of $CeO_2$ is 6.0% or more in terms of mass% based on oxides.

6. The glass according to any one of claims 1 to 3, further comprising, in terms of mass% based on oxides: 10% or less of $B_2O_3$.

7. The glass according to any one of claims 1 to 3, further comprising at least one of $Na_2O$, $K_2O$, and $Li_2O$, wherein the glass has a total content $R_2O$ of $Na_2O$, $K_2O$, and $Li_2O$ of 7% to 25% in terms of mass% based on oxides.

8. The glass according to any one of claims 1 to 3, being substantially free of BaO.

9. The glass according to any one of claims 1 to 3, having a content of NiO of 0.08% or less in terms of mass% based on oxides.

10. The glass according to any one of claims 1 to 3, further comprising, in terms of mass% based on oxides:
    0% to 0.8% of $TiO_2$.

11. The glass according to any one of claims 1 to 3, further comprising, in terms of mass% based on oxides:
    0% to 0.1% of $TiO_2$.

12. The glass according to any one of claims 1 to 3, having a thickness of 0.2 mm or less.

13. The glass according to any one of claims 1 to 3, having a rectangle shape that has a main surface having one side of 50 cm or more and 300 cm or less.

14. The glass according to any one of claims 1 to 3, having a visible light average transmittance of 80% or more after being irradiated with an electron beam of $1 \times 10^{15}$ electrons/$cm^2$ at an energy amount of 1 MeV.

15. The glass according to any one of claims 1 to 3, having an average thermal expansion coefficient at 50°C to 350°C of $20 \times 10^{-7}$/°C to $100 \times 10^{-7}$/°C.

16. The glass according to any one of claims 1 to 3, being chemically strengthenable.

17. The glass according to any one of claims 1 to 3, being a cover glass for a solar cell.

18. The glass according to any one of claims 1 to 3, being a glass for cutting an electron beam.

19. The glass according to any one of claims 1 to 3, being a glass for cutting an ultraviolet ray.

## INTERNATIONAL SEARCH REPORT

| International application No. |
|---|
| **PCT/JP2024/011493** |

| A. | CLASSIFICATION OF SUBJECT MATTER |
|---|---|

*C03C 3/095*(2006.01)i; *C03C 4/08*(2006.01)i; *C03C 21/00*(2006.01)i; *H01L 31/048*(2014.01)i
FI: C03C3/095; H01L31/04 560; C03C4/08; C03C21/00 101

According to International Patent Classification (IPC) or to both national classification and IPC

| B. | FIELDS SEARCHED |
|---|---|

Minimum documentation searched (classification system followed by classification symbols)

C03C1/00-14/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

INTERGLAD

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2023/022074 A1 (NIPPON ELECTRIC GLASS CO., LTD.) 23 February 2023 (2023-02-23) | 1-3, 5-19 |
| | paragraphs [0039], [0041], [0048], [0074]-[0075], [0085] | |
| A | | 4 |
| X | JP 9-194228 A (PILKINGTON PLC) 29 July 1997 (1997-07-29) | 1, 3, 6-7, 9-19 |
| | paragraphs [0015], [0025], [0027]-[0028], [0030]-[0031], [0037] | |
| A | | 2, 4, 5, 8 |
| X | JP 2000-226228 A (CORNING INC.) 15 August 2000 (2000-08-15) | 1-2, 6-19 |
| | paragraphs [0012], [0021], [0024]-[0025], [0032] | |
| A | | 3-5 |
| X | JP 63-95138 A (PILKINGTON PLC) 26 April 1988 (1988-04-26) | 1-2, 5, 7-19 |
| | p. 5, upper left column, line 14 to upper right column, line 1, table 1 | |
| A | | 3-4, 6 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 May 2024** | **04 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT

International application No.

**PCT/JP2024/011493**

### C. DOCUMENTS CONSIDERED TO BE RELEVANT

| Category* | Citation of document, with indication, where appropriate, of the relevant passages | Relevant to claim No. |
|---|---|---|
| X | JP 5-85768 A (PILKINGTON PLC) 06 April 1993 (1993-04-06) paragraphs [0017]-[0018], [0028]-[0031] | 1-3, 5-19 |
| A | | 4 |
| X | JP 63-297240 A (CORNING GLASS WORKS) 05 December 1988 (1988-12-05) tables 1-2, p. 4, upper left column, lines 10-20 | 1-2, 5-13, 15-19 |
| A | | 3-4, 14 |
| X | CN 103833223 A (QINHUANGDAO XINGJIAN SPECIAL GLASS CO., LTD.) 04 June 2014 (2014-06-04) paragraph [0002], examples 1-3 | 1-2, 5-7, 9-19 |
| A | | 3-4, 8 |
| X | JP 2014-196227 A (NIPPON ELECTRIC GLASS CO., LTD.) 16 October 2014 (2014-10-16) paragraphs [0002], [0065], [0074] | 1-3, 6-11, 13, 15-19 |
| A | | 4-5, 12, 14 |
| X | WO 2012/102176 A1 (ASAHI GLASS COMPANY, LIMITED) 02 August 2012 (2012-08-02) tables 1-5 | 1-2, 4, 6-10, 13, 15-16, 18-19 |
| A | | 3, 5, 11-12, 14, 17 |

Form PCT/ISA/210 (second sheet) (July 2022)

## INTERNATIONAL SEARCH REPORT
### Information on patent family members

| International application No. |
|---|
| **PCT/JP2024/011493** |

| Patent document cited in search report | | | Publication date (day/month/year) | Patent family member(s) | Publication date (day/month/year) |
|---|---|---|---|---|---|
| WO | 2023/022074 | A1 | 23 February 2023 | (Family: none) | |
| JP | 9-194228 | A | 29 July 1997 | US 6180218 B1<br>tables 1-2, column 4, lines<br>48-56, column 7, lines 37-54<br>EP 779252 A1<br>KR 10-1997-0042363 A | |
| JP | 2000-226228 | A | 15 August 2000 | US 6207603 B1<br>column 2, lines 29-33, table 1,<br>column 5, lines 41-49<br>EP 1026130 A1 | |
| JP | 63-95138 | A | 26 April 1988 | US 5017521 A<br>column 4, lines 38-49, table 1<br>EP 261885 A1<br>KR 10-1988-0003841 A | |
| JP | 5-85768 | A | 06 April 1993 | US 5219801 A<br>column 3, lines 26-32, table 2<br>EP 505061 A2<br>KR 10-1992-0017964 A | |
| JP | 63-297240 | A | 05 December 1988 | US 4746634 A<br>tables 1-2, column 4, lines 6-10 | |
| CN | 103833223 | A | 04 June 2014 | (Family: none) | |
| JP | 2014-196227 | A | 16 October 2014 | (Family: none) | |
| WO | 2012/102176 | A1 | 02 August 2012 | US 2013/0306900 A1<br>tables 1-5<br>CN 103328397 A<br>KR 10-2014-0009219 A | |

Form PCT/ISA/210 (patent family annex) (July 2022)

**EP 4 692 007 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006264994 A
- JP 2023054194 A
- JP 2023144621 A